# EUROPEAN PATENT SPECIFICATION

(11) **EP 3 249 688 B1**
(45) Date of publication and mention of the grant of the patent: **28.10.2020**
(21) Application number: 17169993.7
(22) Date of filing: 08.05.2017
(51) Int. Cl.: H01L 27/12, H01L 21/762, H01L 21/84

(54) **SEMICONDUCTOR DEVICE**
HALBLEITERBAUELEMENT
DISPOSITIF À SEMI-CONDUCTEURS

(30) Priority: 24.05.2016 JP 2016102958
(43) Date of publication of application: 29.11.2017
(73) Proprietor: Renesas Electronics Corporation, Tokyo 135-0061 (JP)
(72) Inventor: TSUBOI, Nobuo, Koutou-ku, Tokyo 135-0061 (JP)
(74) Representative: Mewburn Ellis LLP

(56) References cited:
- JP-A- 2014 236 097
- US-A1- 2013 119 469

## Description

### CROSS-REFERENCE TO RELATED APPLICATION

The present application claims priority from Japanese Patent Application No. 2016-102958 filed on May 24, 2016.

### TECHNICAL FIELD OF THE INVENTION

The present invention relates to a semiconductor device. More particularly, the present invention relates to a technique effectively applied to a semiconductor device using an SOI substrate.

### BACKGROUND OF THE INVENTION

As a semiconductor device capable of suppressing short-channel characteristics and suppressing variation in an element, a semiconductor device using an SOI substrate has been currently used. The SOI substrate includes a support substrate made of Si (silicon) or others, an insulating layer (also referred to as a BOX (Buried Oxide) layer) on the support substrate, and a thin semiconductor layer made of Si or others on the insulating layer. If a MISFET is formed on the SOI substrate, mobility is improved, and variation in an element due to impurity fluctuation can be improved.

For example, Patent Document 1 (Japanese Patent Application Laid-Open Publication No. 2014-236097) discloses a technique for forming an epitaxial layer formed on an SOI layer in an upper part of an SOI substrate with a large width so as to cover an end of an upper surface of an element isolation region adjacent to the SOI layer. This manner can prevent connection of a contact plug whose formation position has shifted to a semiconductor substrate below the SOI layer.

Patent Document 2 (Japanese Patent Application Laid-Open Publication No. 2006-190823) discloses a semiconductor device in which a transistor including a gate electrode, a gate insulating film, and a sidewall insulating film is formed on a semiconductor substrate including an active region and a trench isolation region and in which a dummy gate wiring is arranged so as not to overlap the active region on the trench isolation region. On a sidewall of the dummy gate wiring, a sidewall insulating film having a width equal to or larger than a distance between an end of the active region and the dummy gate wiring is formed.

US 2013/0119469 A1 discloses a semiconductor device.

### SUMMARY OF THE INVENTION

The present inventor has engaged in research and development of the semiconductor device using the SOI substrate as described above, and has earnestly studied improvement in characteristics of the semiconductor device. When the MISFET (Metal Insulator Semiconductor Field Effect Transistor: MISFET-type field effect transistor) is formed in the active region on the SOI substrates so as to form a contact plug on a source/drain region in the MISFET, the positional shift of the contact plug becomes a problem.

More specifically, the shift of the formation position of the contact plug from an upper portion of the semiconductor layer toward the element isolation region has a risk in which the contact plug reaches the insulating layer and the support substrate. If a so-called bulk substrate made of silicon is used, a junction is formed on the substrate by the source/drain region. Therefore, leakage from the contact plug to the substrate is small. On the other hand, a junction is not formed on the support substrate which is the lower layer of the insulating layer. Therefore, leakage to the substrate becomes large.

Thus, for the semiconductor device using the SOI substrate, it is desirable to study a configuration of the semiconductor device for reducing the above-described leakage and improving the characteristics of the semiconductor device.

Other object and novel characteristics will be apparent from the description of the present specification and the accompanying drawings.

The summary of the typical embodiment of the embodiments disclosed in the present application will be briefly described as follows.

The present invention provides a semiconductor device as set forth in claim 1.

According to a semiconductor device described in the following typical embodiment disclosed in the present application, characteristics of the semiconductor device can be improved.

### BRIEF DESCRIPTIONS OF THE DRAWINGS

FIG. 1 is a cross-sectional view illustrating a first configuration of a semiconductor device according to a first embodiment;
FIG. 2A is a plan view illustrating the first configuration of the semiconductor device according to the first embodiment;
FIG. 2B is a plan view illustrating the first configuration of the semiconductor device according to the first embodiment;
FIGs. 3A and 3B are diagrams respectively illustrating configurations of semiconductor devices according to a first comparative example and a second comparative example;
FIG. 4 is a cross-sectional view illustrating a second configuration of the semiconductor device according to the first embodiment;
FIG. 5 is a cross-sectional view illustrating a third configuration of the semiconductor device according to the first embodiment;
FIG. 6 is a cross-sectional view illustrating a configuration of a semiconductor device according to a third comparative example;
FIG. 7 is a cross-sectional view illustrating a fourth configuration of the semiconductor device according to the first embodiment;
FIG. 8 is a cross-sectional view illustrating a configuration of a semiconductor device according to an application example of the first embodiment;
FIG. 9 is a plan view illustrating the configuration of the semiconductor device according to the application example of the first embodiment;
FIG. 10 is a cross-sectional view illustrating the configuration of the semiconductor device according to a fourth comparative example;
FIG. 11 is a cross-sectional view illustrating a process for manufacturing the semiconductor device according to the first embodiment;
FIG. 12 is a cross-sectional view illustrating a process for manufacturing the semiconductor device according to the first embodiment;
FIG. 13 is a cross-sectional view illustrating a process for manufacturing the semiconductor device according to the first embodiment;
FIG. 14 is a cross-sectional view illustrating a process for manufacturing the semiconductor device according to the first embodiment;
FIG. 15 is a cross-sectional view illustrating a process for manufacturing the semiconductor device according to the first embodiment;
FIG. 16 is a cross-sectional view illustrating a process for manufacturing the semiconductor device according to the first embodiment;
FIG. 17 is a cross-sectional view illustrating a process for manufacturing the semiconductor device according to the first embodiment;
FIG. 18 is a cross-sectional view illustrating a process for manufacturing the semiconductor device according to the first embodiment;
FIG. 19 is a cross-sectional view illustrating a process for manufacturing the semiconductor device according to the first embodiment;
FIG. 20 is a cross-sectional view illustrating a process for manufacturing the semiconductor device according to the first embodiment;
FIG. 21 is a cross-sectional view illustrating a process for manufacturing the semiconductor device according to the first embodiment;
FIG. 22 is a cross-sectional view illustrating a process for manufacturing the semiconductor device according to the first embodiment;
FIG. 23 is a cross-sectional view illustrating a process for manufacturing the semiconductor device according to the first embodiment;
FIG. 24 is a cross-sectional view illustrating a process for manufacturing the semiconductor device according to the first embodiment;
FIG. 25 is a cross-sectional view illustrating a process for manufacturing the semiconductor device according to the first embodiment;
FIG. 26 is a cross-sectional view illustrating a process for manufacturing the semiconductor device according to the first embodiment;
FIG. 27 is a cross-sectional view illustrating a process for manufacturing the semiconductor device according to the first embodiment;
FIG. 28 is a cross-sectional view illustrating a process for manufacturing the semiconductor device according to the first embodiment;
FIG. 29 is a plan view illustrating a configuration of a semiconductor device according to a first modification example of a second embodiment;
FIG. 30 is a plan view illustrating a configuration of a semiconductor device according to a second modification example of the second embodiment;
FIG. 31 is a plan view illustrating a configuration of a semiconductor device according to a third modification example of the second embodiment;
FIG. 32 is a plan view illustrating an example of a configuration of a semiconductor device according to a fourth modification example of the second embodiment; and
FIG. 33 is a cross-sectional view illustrating a configuration of a semiconductor device of another modification example.

### DESCRIPTIONS OF THE PREFERRED EMBODIMENTS

In the embodiments described below, the invention will be described in a plurality of sections or embodiments when required as a matter of convenience. However, these sections or embodiments are not irrelevant to each other unless otherwise stated, and the one relates to the entire or a part of the other as a modification example, details, or a supplementary explanation thereof. Also, in the embodiments described below, when referring to the number of elements (including number of pieces, values, amount, range, and others), the number of the elements is not limited to a specific number unless otherwise stated or except the case where the number is apparently limited to a specific number in principle. The number larger or smaller than the specified number is also applicable.

Further, in the embodiments described below, it goes without saying that the components (including element steps) are not always indispensable unless otherwise stated or except the case where the components are apparently indispensable in principle. Similarly, in the embodiments described below, when the shape of the components, positional relation thereof, and others are mentioned, the substantially approximate and similar shapes and others are included therein unless otherwise stated or except the case where it is conceivable that they are apparently excluded in principle. The same goes for the numbers (including number of pieces, numerical values, amount, range, and others).

Hereinafter, embodiments of the present invention will be described in detail with reference to the accompanying drawings. Note that components having the same function are denoted by the same reference symbols throughout all the drawings for describing the embodiment, and the repetitive description thereof will be omitted. If there are a plurality of similar members (portions), an individual or specific portion is illustrated with addition of a sign to a symbol of a generic term. In addition, the description of the same or similar portions is not repeated in principle unless otherwise particularly required in the following embodiments.

Also, in some drawings used in the embodiments, hatching is omitted even in a cross-sectional view so as to make the drawings easy to see. In addition, hatching is used even in a plan view so as to make the drawings easy to see.

Also, in the cross-sectional view and the plan view, a size of each portion does not correspond to that of the practical device, and the specific portion may be illustrated to be relatively large in order to easily understand the drawings in some cases. Also, even in the cross-sectional view and the plan view corresponding to each other, the specific portion may be illustrated to be relatively large in order to easily understand the drawings in some cases.

### (First Embodiment)

Hereinafter, a semiconductor device according to the present embodiment will be described in detail with reference to the drawings.

### [Description of Structure]

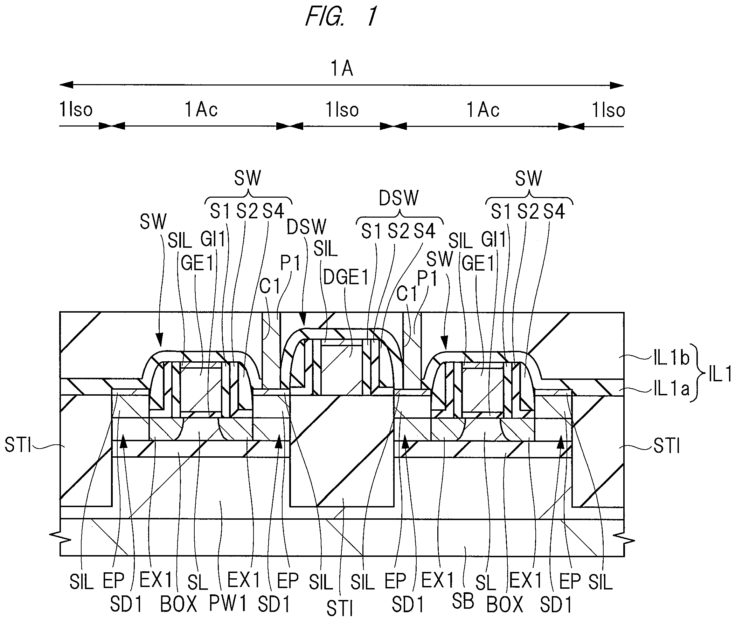

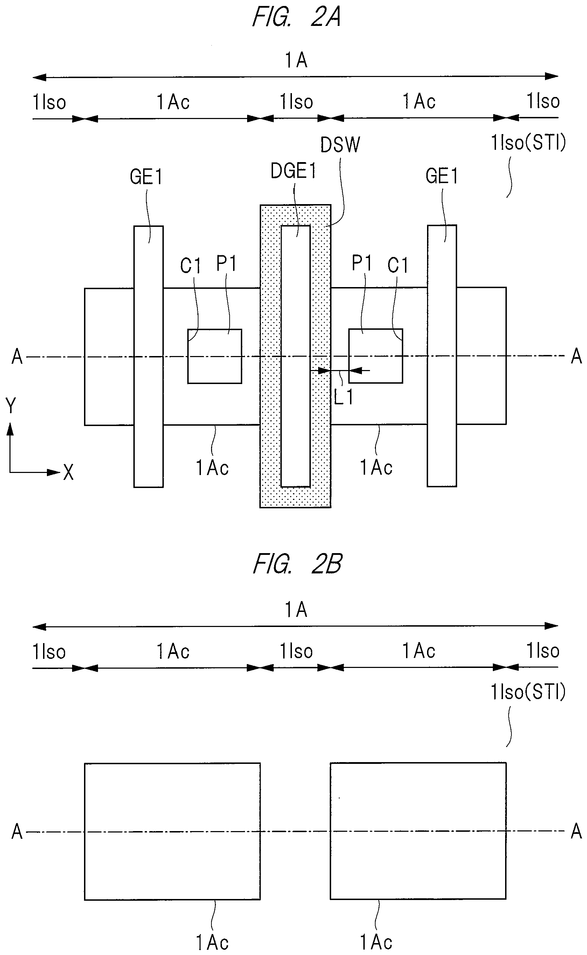

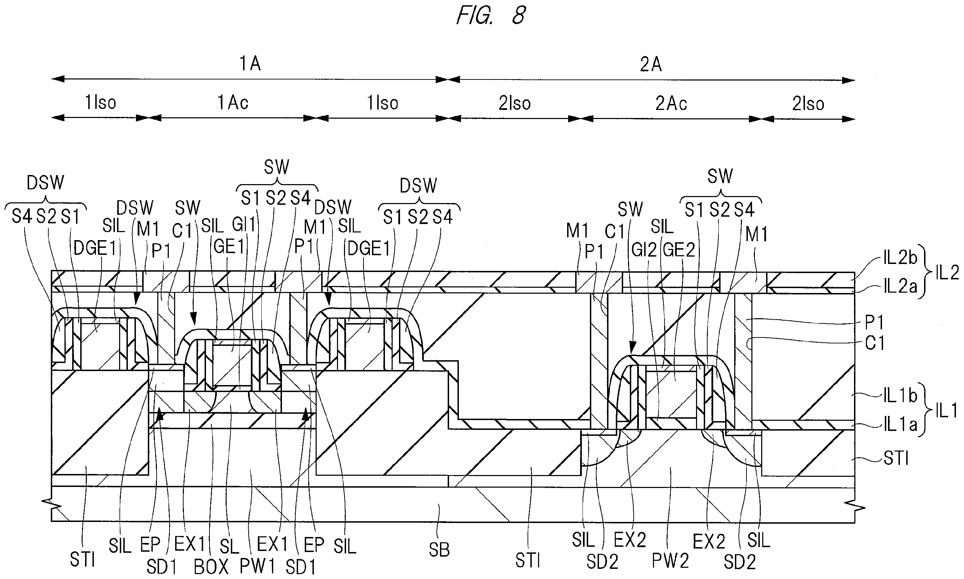

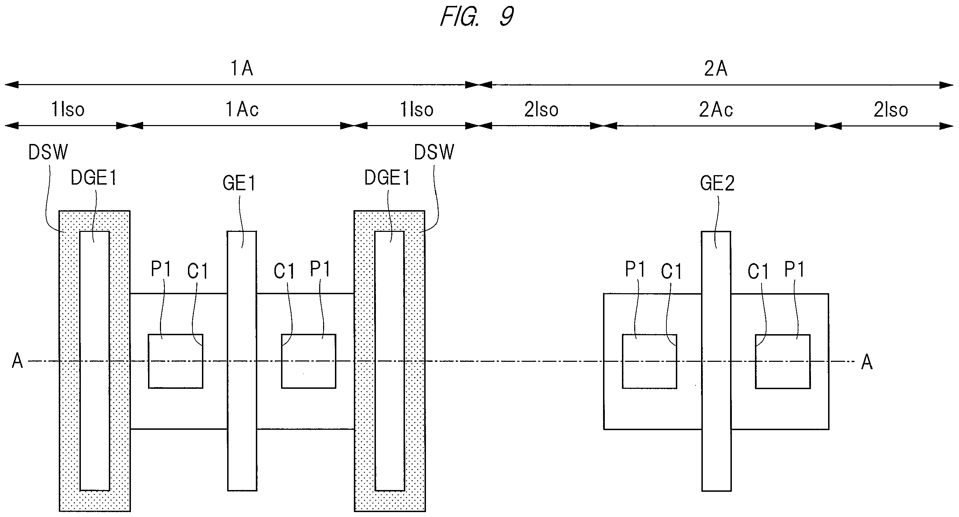

FIG. 1 is a cross-sectional view illustrating a first configuration of a semiconductor device according to the present embodiment, and FIGs. 2A and 2B are plan views respectively illustrating the first configuration of the semiconductor device according to the present embodiment. FIG. 1 corresponds to a cross section taken along a line A-A illustrated in FIG. 2A. FIG. 2B is a plan view of two active regions 1Ac. In order to make the drawings easy to understand, note that a sidewall film SW arranged in periphery of a gate electrode GE1 is omitted in the plan views. As described later, the semiconductor device according to the present embodiment includes an SOI region 1A and a bulk region 2A in some cases (see FIGs. 8 and 9). FIGs. 1 and 2 illustrate the SOI region 1A.

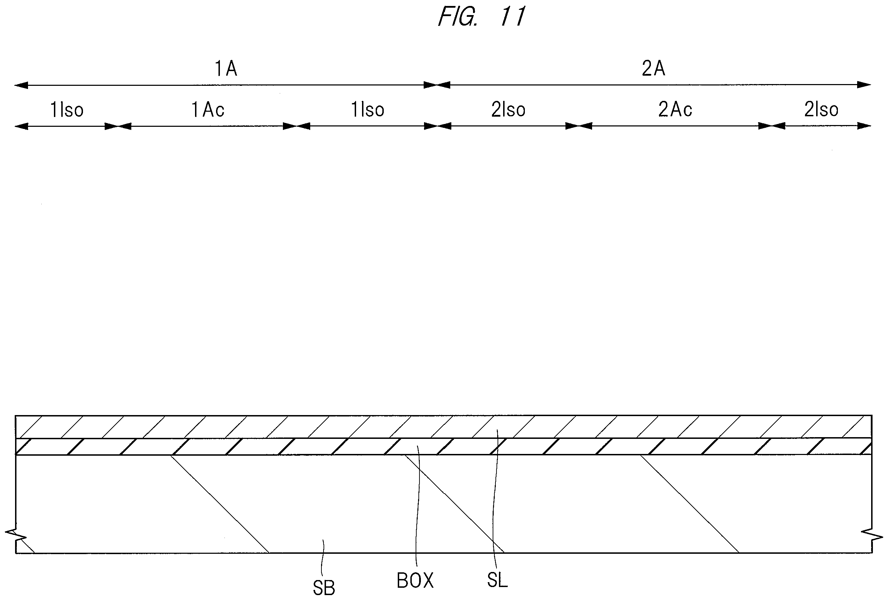

An SOI substrate includes a semiconductor layer SL arranged on a support substrate SB via an insulating layer BOX (see FIG. 11) . The support substrate SB is a semiconductor substrate made of, for example, single crystalline silicon (Si), and the insulating layer BOX is a layer made of oxide silicon. The semiconductor layer SL is a layer made of single crystalline silicon. The thickness of the insulating layer BOX is, for example, about 10 nm to 30 nm. The thickness of the semiconductor layer SL is, for example, about 10 nm to 30 nm.

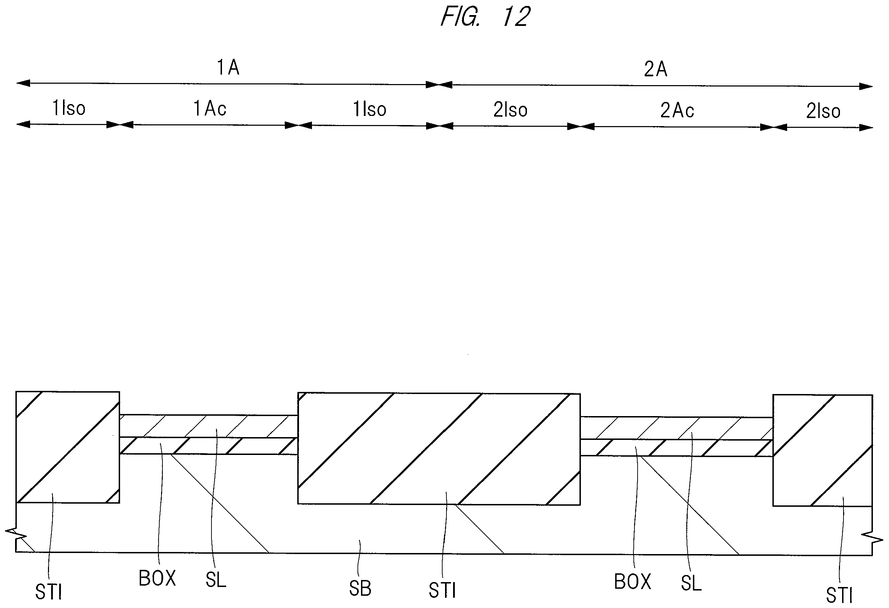

As illustrated in FIGs. 1 and 2, the SOI region 1A includes the two active regions 1Ac and element isolation regions 1Iso two of which surround each of the active regions 1Ac. As described later, the element isolation region 1Iso is a formation region of an element isolation insulating film STI embedded in an element isolation trench, and the active region 1Ac is an exposure region of the semiconductor layer SL surrounded by the element isolation insulating film STI (see FIG. 12 and FIG. 2B). As illustrated in FIG. 2B, the two active regions 1Ac each have a substantially rectangular shape, and are spaced apart from each other. A region between the two active regions 1Ac becomes the element isolation region 1Iso. Note that a well (here, p-type well PW1) containing impurities (here, p-type impurities) is arranged in the support substrate SB below the semiconductor layer SL constituting the active region.

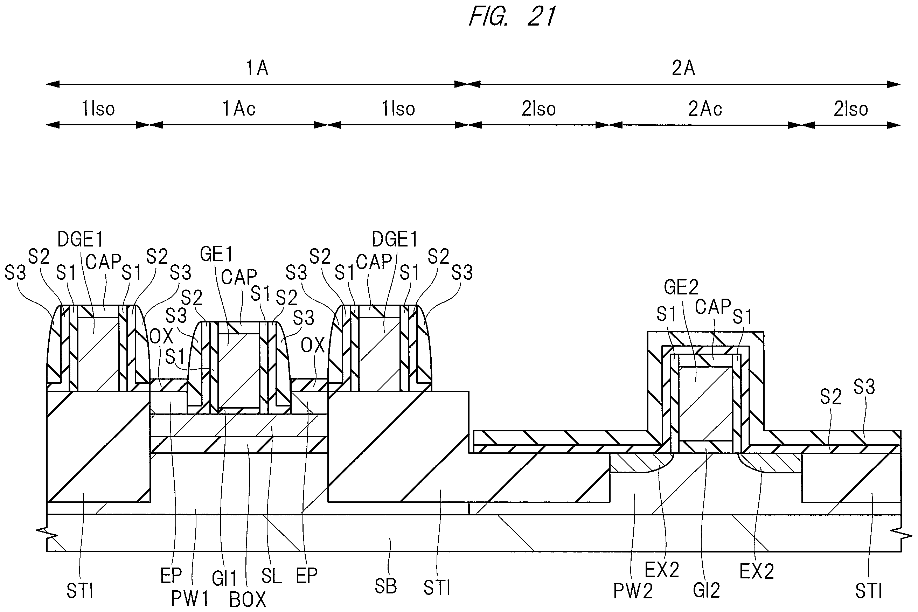

A MISFET is formed in each of the two active regions 1Ac. The MISFET has the gate electrode GE1 formed on the semiconductor layer SL via a gate insulating film GI1 and a source/drain region formed in the semiconductor layer SL on each of both sides of the gate electrode GE1. The source/drain region is a source/drain region having an LDD structure. Accordingly, the source/drain region includes an n-type low-concentration impurity region EX1 formed to be self-aligned with the gate electrode GE1 or others and an n-type high-concentration impurity region SD1 formed to be self-aligned with a composite (a composite pattern or a composite forming object) of the gate electrode GE1 with a sidewall film SW of a sidewall of the gate electrode. The n-type high-concentration impurity region SD1 has a higher impurity concentration than that of the n-type low-concentration impurity region EX1. Here, an epitaxial layer EP is arranged on the semiconductor layer SL (see FIG. 21). The epitaxial layer EP contains n-type impurities (e.g., phosphorous (P) or arsenic (As)) at a high concentration. Accordingly, here, the n-type high-concentration impurity region SD1 is formed of the epitaxial layer EP and the semiconductor layer SL. In other words, the n-type high-concentration impurity region SD1 is an n-type impurity region formed in a stacked portion of the epitaxial layer EP and the semiconductor layer SL.

The sidewall film SW includes a first film S1 formed on a sidewall of the gate electrode GE1, a second film S2 formed on a sidewall of the first film S1 and on the semiconductor layer SL (the n-type low-concentration impurity region EX1), and a fourth film S4 formed on a sidewall of the second film S2. The first film S1 is, for example, a silicon oxide film, and each of the second film S2 and the fourth film S4 is, for example, a silicon nitride film.

On the element isolation region 1Iso between the two active regions, a dummy gate electrode DGE1 is formed. The dummy gate electrode DGE1 is composed of a film in the same layer as that of the gate electrode GE1. "The films in the same layer" are, for example, films made of the same component material in the same process as each other. A dummy sidewall film DSW is formed on a sidewall on each of both sides of the dummy gate electrode DGE1. The dummy sidewall film DSW is composed of a film in the same layer as the sidewall film SW. Accordingly, the dummy sidewall film DSW is formed of the first film S1, the second film S2, and the fourth film S4. The dummy gate electrode DGE1 and the dummy sidewall films DSW on both the sides thereof form a structure body similar to the MISFET on the active region 1Ac, and therefore, are collectively referred to as a pseudo transistor in some cases. However, the pseudo transistor is also formed in the element isolation region 1Iso, and therefore, cannot operate even if a potential is applied to the dummy gate electrode DGE1.

A metal silicide layer (a compound of a metal and a semiconductor layer constituting the source/drain region) SIL is formed in each upper portion of the gate electrode GE1, the source/drain region (here, the epitaxial layer EP), and the dummy gate electrode DGE1. An interlayer insulating film IL1 is formed on the MISFET. The interlayer insulating film IL1 includes a stacked film of a thin silicon nitride film (also referred to as a liner film) ILla and a silicon oxide film IL1b thereon. A plug (contact plug) P1 is formed above the source/drain region (here, the epitaxial layer EP) in the MISFET. The plug P1 is composed of a conductive film embedded in a contact hole C1. A distance (the shortest distance) from the plug P1 to a boundary between the active region 1Ac and the element isolation region 1Iso is defined as "L1" (see FIG. 2A).

Here, in the present embodiment, the dummy gate electrode DGE1 is arranged on the element isolation region 1Iso, and the dummy sidewall film DSW is further formed on both sides of the dummy gate electrode DGE1. The dummy sidewall film DSW is arranged along a boundary between the active region 1Ac and the element isolation region 1Iso. More preferably, one end of the dummy sidewall film DSW is arranged so as to match the boundary between the active region 1Ac and the element isolation region 1Iso. Alternatively, the dummy sidewall film DSW is arranged to overlap (cover) the boundary between the active region 1Ac and the element isolation region 1Iso.

By the above-described configuration, a failure due to the shift of the plug P1 can be solved. A failure due to a hollow portion (recess or STI divot) "R" along the boundary between the active region 1Ac and the element isolation region 1Iso can be solved. As a result, the characteristics of the semiconductor device such as a decrease in a leakage current, a TDDB (Time Dependent Dielectric Breakdown) life, and others can be improved.

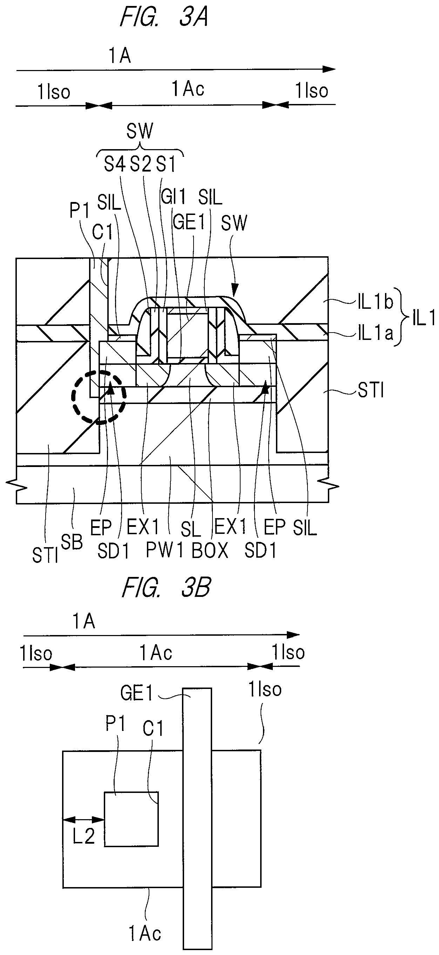

FIGs. 3A and 3B are diagrams illustrating configurations of semiconductor devices in a first comparative example and a second comparative example, respectively, FIG. 3A is a cross-sectional view illustrating the configuration in the first comparative example, and FIG. 3B is a plan view illustrating the configuration in the second comparative example. Note that portions corresponding to those in the first embodiment (FIG. 1, etc.) are denoted with the same reference symbols, and the description thereof is omitted.

When the plug P1 is formed so as to shift in the first comparative example without the dummy gate electrode DGE1 and the dummy sidewall film DSW as illustrated in FIG. 3A, there is a risk in which an element isolation insulating film STI is deeply etched at the formation of the contact hole C1 so that the bottom of the contact hole C1 reaches the insulating layer BOX and the support substrate (a p-type well PW1) SB (see a portion enclosed by a broken line circle). When a conductive film is embedded in such a deep contact hole C1 to form the plug P1, a breakdown voltage between the plug P1 and the support substrate SB decreases, and the plug P1 and the support substrate SB are electrically conducted to each other to increase a leakage current.

In order to avoid such a failure due to the shift of the plug P1, the distance (the shortest distance) L2 from the plug P1 to the boundary between the active region 1Ac and the element isolation region 1Iso can be ensured to be large (L2 > L1) as illustrated in FIG. 3B. However, in such a case, the active region 1Ac becomes large, and this prevents downsizing and high integration of the semiconductor device. As described later, in a bulk region 2A, it is hardly required to consider the shift of the plug P1, and therefore, the above-described distance can be reduced. For example, a case that is applicable with the distance L1 illustrated in FIG. 2A exists. In such a case, the SOI region 1A and the bulk region 2A are different from each other in the distance (L1, L2, margin) from the plug P1 to the boundary between the active region 1Ac and the element isolation region 1Iso. That is, a different design rule (design manual) is applied for each of the regions, and a circuit design becomes difficult.

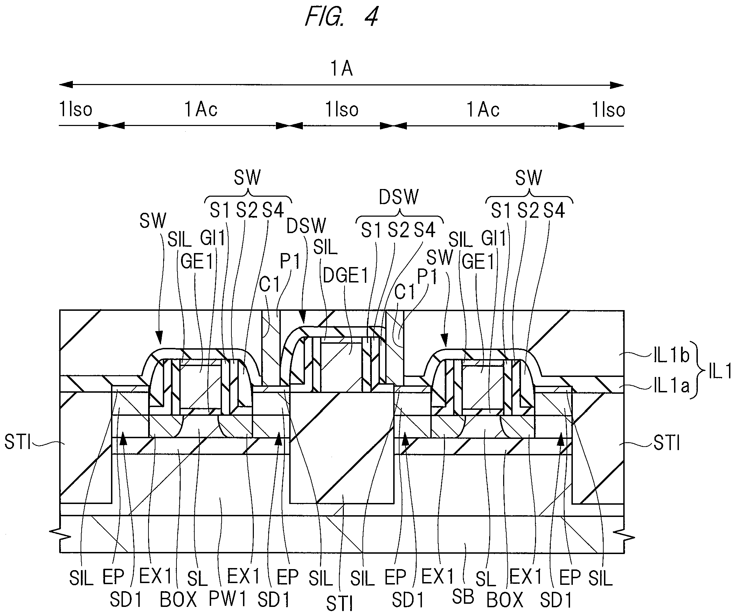

On the other hand, in the present embodiment, even when a contact hole C1 is formed so as to shift as illustrated in FIG. 4, the dummy sidewall film DSW can prevent the contact hole C1 from deeply reaching down to, for example, the insulating layer BOX and the support substrate SB. FIG. 4 is a cross-sectional view illustrating a second configuration of the semiconductor device according to the present embodiment. Accordingly, an electrical insulated state between the plug P1 and the support substrate SB can be maintained, and the leakage current can be reduced. The distance L1 from the plug P1 to the boundary between the active region 1Ac and the element isolation region 1Iso can be reduced, so that the semiconductor device can be downsized and highly integrated. As described later, the SOI region 1A and the bulk region 2A can be designed by using a similar design rule to each other, so that the circuit design can be made easy.

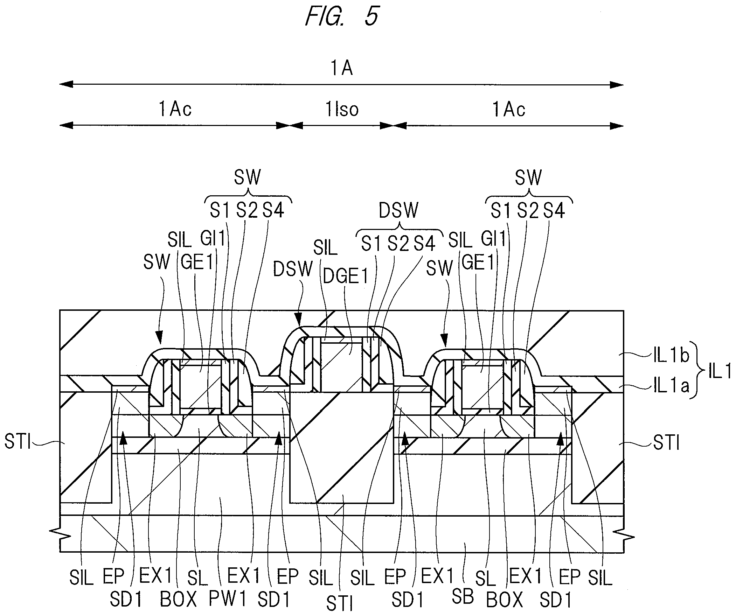

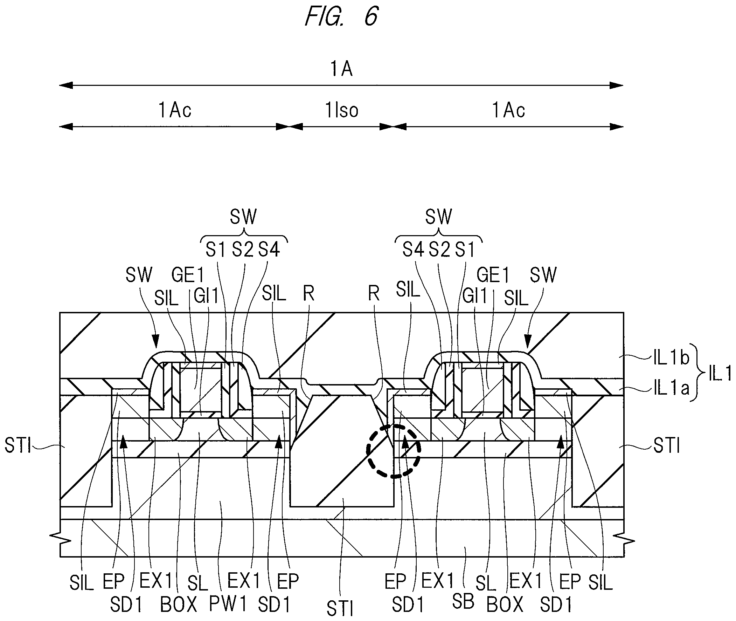

FIG. 5 is a cross-sectional view illustrating a third configuration of the semiconductor device according to the present embodiment. In FIG. 5, the plug P1 is not formed above the source/drain region (here, the epitaxial layer EP) in the MISFET. Thus, even in a region where the plug P1 is not formed, the failure due to the hollow portion (a recess or an STI divot) "R" caused along a boundary between an active region 1Ac and an element isolation region 1Iso can be solved. FIG. 6 is a cross-sectional view illustrating a configuration of a semiconductor device according to a third comparative example. As illustrated in FIG. 6, in the third comparative example without a dummy gate electrode DGE1 and a dummy sidewall film DSW, the hollow portion (recess or STI divot) R may occur along a boundary between an active region 1Ac and an element isolation region 1Iso. That is, in the boundary between the active region 1Ac and the element isolation region 1Iso, a surface of the element isolation region (an element isolation insulating film STI) 1Iso is lower than a surface of the active region (a semiconductor layer SL) 1Ac. Such a hollow portion R occurs in a process for removing an oxide film, a process for developing a photoresist film, and others which are performed while the surface of the element isolation insulating film STI is exposed. The larger the number of processes is, the deeper the hollow portion R tends to be. If impurities (here, n-type or p-type impurities) are implanted into the surface of the element isolation insulating film STI, a reduction speed of the film thickness caused by the above-described processes increases, and the hollow portion R tends to deepen.

If the hollow portion R occurs as described above, a metal silicide layer SIL is formed at a deep position along the hollow portion R. Thus, there is a risk in which an end of the metal silicide layer SIL reaches the vicinity of the insulating layer BOX and the support substrate SB (see a portion enclosed by a broken-line circle) . Thus, a breakdown voltage of the insulating layer BOX between the metal silicide layer SIL and the support substrate SB decreases. Thus, a TDDB life may decrease, and dielectric breakdown of the insulating layer BOX may occur. The occurrence of the above-described hollow portion R causes a failure in which an epitaxial layer EP growing on the semiconductor layer SL also grows in a gate length direction.

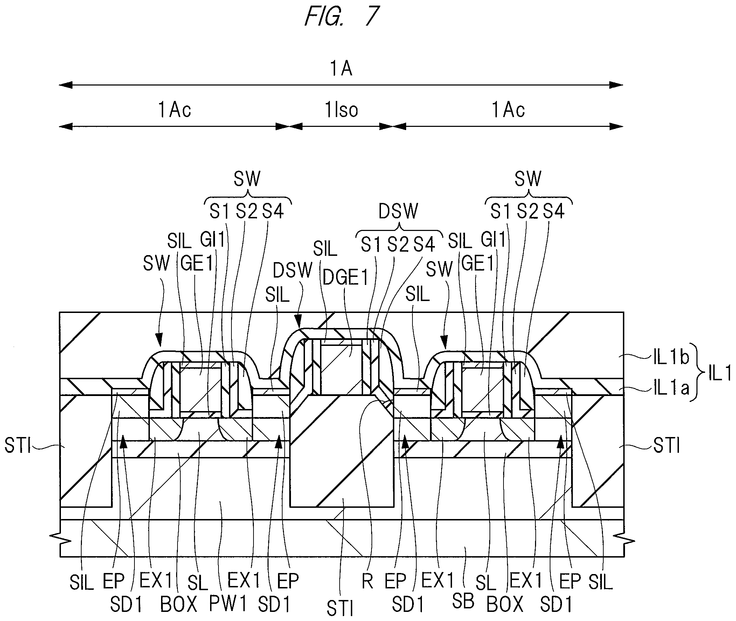

On the other hand, in the present embodiment, as illustrated in FIG. 7, a hollow portion R caused along a boundary between an active region 1Ac and an element isolation region 1Iso becomes smaller than the conventional one because of a dummy gate electrode DGE1 and a dummy sidewall film DSW (S1, S2, S4). Even if a hollow portion R occurs, the hollow portion R can be embedded by the dummy sidewall film DSW. FIG. 7 is a cross-sectional view illustrating a fourth configuration of the semiconductor device according to the present embodiment.

Thus, in the present embodiment, a metal silicide layer SIL is not formed to a deep position along the hollow portion R, and the decrease in the breakdown voltage of the insulating layer BOX can be avoided. That is, the decrease of the TDDB life and the dielectric breakdown of the insulating layer BOX can be avoided.

### (Application Example)

Then, a semiconductor device including an SOI region 1A and a bulk region 2A will be described. More specifically, if the semiconductor device is formed using the SOI substrate 1A, an MISFET (here, referred to as an SOI-MISFET) formed on the above-described semiconductor layer SL and a MISFET (here, referred to as a bulk MISFET) formed on a support substrate (so-called bulk substrate) SB from which an insulating layer BOX and the semiconductor layer SL are removed are mounted together in some cases. Note that it is appropriately selected which one of the SOI-MISFET and the bulk MISFET is to be formed as needed, depending on a circuit function to be requested.

FIG. 8 is a cross-sectional view illustrating a configuration of the semiconductor device according to the application example of the present embodiment, and FIG. 9 is a plan view illustrating the configuration of the semiconductor device according to the applications example of the present embodiment. FIG. 8 corresponds to a cross section taken along, for example, a line A-A illustrated in FIG. 9.

As illustrated in FIG. 8 and 9, the semiconductor device according to the present application example includes an SOI-MISFET formed in an SOI region 1A and a bulk MISFET formed in a bulk region 2A.

Here, the SOI-MISFET formed in the SOI region 1A is a MISFET used for, for example, a logic circuit or others and driven at a relatively low potential. Particularly, the SOI-MISFET formed in the SOI region 1A can operate at a high speed, and is low in power consumption. Therefore, the SOI-MISFET is used for a logic circuit (a standard cell) having such high-level requests.

The bulk MISFET formed in the bulk region 2A is used for, for example, an input/output circuit (also referred to as an I/O circuit) . The bulk MISFET is driven by, for example, a relatively high potential (e.g., about 3.3 V). Thus, the bulk MISFET is a MISFET having, for example, a high breakdown voltage, and is larger in a thickness and larger in a gate length than the SOI-MISFET.

In the SOI region 1A, a semiconductor layer SL is arranged on a support substrate SB via an insulating layer BOX. The SOI-MISFET is formed on a main surface of the semiconductor layer SL.

In the bulk region 2A, the insulating layer BOX and the semiconductor layer SL on the support substrate SB are not formed. The bulk MISFET is formed on a main surface of the support substrate SB. Since the insulating layer BOX and the semiconductor layer SL on the support substrate SB are removed in the bulk region 2A as described above, an upper surface of the support substrate SB in the bulk region 2A is at a position lower than an upper surface of the semiconductor substrate SL in the SOI region 1A.

In the SOI region 1A, an active region 1Ac where the SOI-MISFET is formed is surrounded by the element isolation regions 1Iso. The element isolation region 1Iso can be said to be an outer peripheral portion positioned on the outer periphery of the active region 1Ac. In the bulk region 2A, an active region 2Ac where the bulk MISFET is formed is surrounded by the element isolation regions 2Iso. The element isolation region 2Iso can be said to be an outer peripheral portion positioned on the outer periphery of the active region 2Ac.

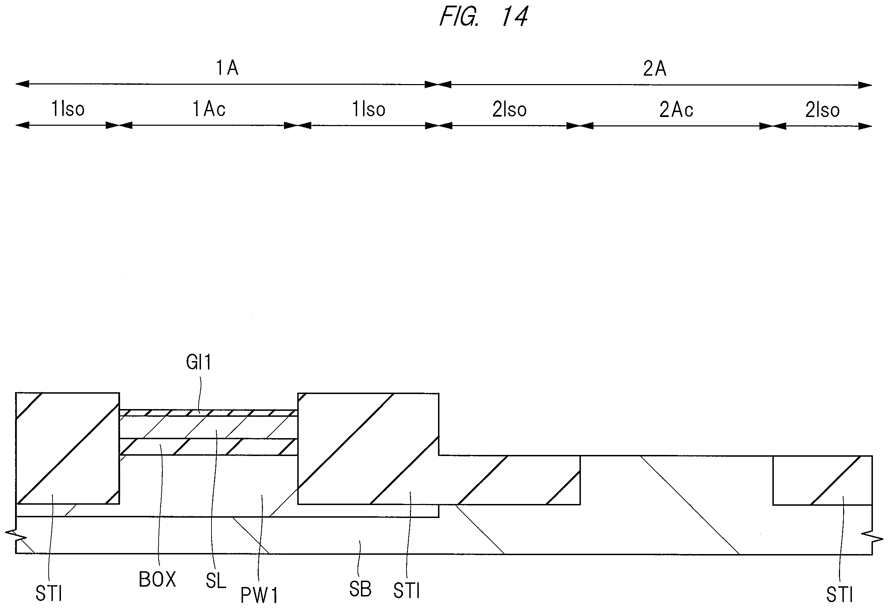

The element isolation region 1Iso is a region where the element isolation insulating film STI embedded in an element isolation trench is formed, and the active region 1Ac is a region where the semiconductor layer SL surrounded by the element isolation insulating film STI is exposed. The element isolation region 2Iso is a region where the element isolation insulating film STI embedded in the element isolation trench is formed, and the active region 2Ac is a region where the support substrate SB surrounded by the element isolation insulating film STI is exposed (see FIG. 14). Note that a well (here, a p-type well PW2) containing impurities (here, p-type impurities) is arranged in the support substrate SB constituting the active region 2Ac.

The SOI-MISFET has a similar configuration to that illustrated in FIG. 1, and includes a gate electrode GE1 formed on the semiconductor layer SL via a gate insulating film GI1 and source/drain regions formed in the semiconductor layer SL on both sides of the gate electrode GE1. A sidewall film SW is arranged on a sidewall of the gate electrode GE1, and the sidewall film SW includes a first film S1, a second film S2 formed on a sidewall of the first film S1 and on the semiconductor layer SL (an n-type low-concentration impurity region EX1), and a fourth film S4 formed on a sidewall of the second film S2. The first film S1 is, for example, a silicon oxide film, and each of the second film S2 and the fourth film S4 is, for example, a silicon nitride film.

Furthermore, in the SOI region 1A illustrated in FIG. 8, a dummy gate electrode DGE1 is formed on the element isolation region 1Iso on both sides of the active region 1Ac. The dummy gate electrode DGE1 is formed of a film in the same layer as the gate electrode GE1. A dummy sidewall film DSW is formed on a sidewall on both sides of the dummy gate electrode DG1. The dummy sidewall film DSW is formed of a film in the same layer as the sidewall film SW. Accordingly, the dummy sidewall film DSW is formed of the first film S1, the second film S2, and the fourth film S4. A metal silicide layer SIL is formed in an upper portion of each of the gate electrode GE1, the source/drain region (here, the epitaxial layer EP), and the dummy gate electrode DGE1.

As illustrated on a right side of FIG. 8, the bulk MISFET includes a gate electrode GE2 formed on the support substrate SB (the p-type well PW2) via a gate insulating film GI2 and source/drain regions formed in the support substrate SB (the p-type well PW2) on both sides of the gate electrode GE2. The source/drain region is a source/drain region having an LDD structure. Accordingly, the source/drain region includes an n-type low-concentration impurity region EX2 formed to be self-aligned with the gate electrode GE2 or others and an n-type high-concentration impurity region SD2 formed to be self-aligned with a composite of the gate electrode GE2 and a sidewall film SW on its sidewall. The n-type high-concentration impurity region SD2 has a higher impurity concentration than that of the n-type low-concentration impurity region EX2. Note that the epitaxial layer EP is not formed in the bulk region 2A.

The sidewall film SW on the sidewall of the gate electrode GE2 includes a first film S1, a second film S2 formed on a sidewall of the first film S1 and on the support substrate SB (the n-type low-concentration impurity region EX2), and a fourth film S4 formed on a sidewall of the second film S2. The sidewall film SW on the sidewall of the gate electrode GE2 is formed of a film in the same layer as the sidewall film SW on the sidewall of the gate electrode GE1. The first film S1 is, for example, a silicon oxide film, and each of the second film S2 and the fourth film S4 is, for example, a silicon nitride film.

In the bulk region 2A illustrated in FIG. 8, a dummy gate electrode DGE1 and a dummy sidewall film DSW are not formed on the element isolation regions 2Iso on both sides of the active region 2Ac.

The metal silicide layer SIL is formed in an upper portion of each of the gate electrode GE1, the source/drain region (here, the epitaxial layer EP), the dummy gate electrode DGE1, the gate electrode GE2, and the source/drain region (here, the n-type high-concentration impurity region SD2). An interlayer insulating film IL1 is formed on the SOI-MISFET and the bulk MISFET. The interlayer insulating film IL1 is formed of a stacked film of a thin silicon nitride film ILla and a silicon oxide film IL1b thereon. A plug P1 is formed above the source/drain region in each of the SOI-MISFET and the bulk MISFET. The plug P1 is formed of a conductive film embedded in a contact hole C1. A wiring M1 is arranged on the plug P1. The wiring M1 is formed in an interlayer insulating film IL2. The interlayer insulating film IL2 is formed of a stacked film of a thin silicon nitride film IL2a and a silicon oxide film IL2 thereon.

Here, in the present embodiment, as similar to illustration in FIG. 1, in the SOI region 1A, the dummy gate electrode DGE1 is arranged on the element isolation region 1Iso, and the dummy sidewall films DSW are further formed on both sides of the dummy gate electrode DGE1, and therefore, a failure due to a shift of the plug P1 can be solved. And, the failure due to the hollow portion (recess or STI divot) R occurring along the boundary between the active region 1Ac and the element isolation region 1Iso can be solved. As a result, improvements in the characteristics of the semiconductor device such as the decrease in the leakage current and the improvement in the TDDB life can be achieved. The SOI region 1A and the bulk region 2A can be designed by a similar design rule to each other, so that a circuit design can be made easy.

Furthermore, in the present embodiment, in the bulk region (I/O region) 2A, a dummy gate electrode DGE2 and a dummy sidewall film DSW are not formed on the element isolation region 2Iso. This is because there is a possibility of charging damage since a potential difference occurs between the dummy gate electrode (DGE2) which is floating and the source/drain region (SD2) in the bulk region 2A.

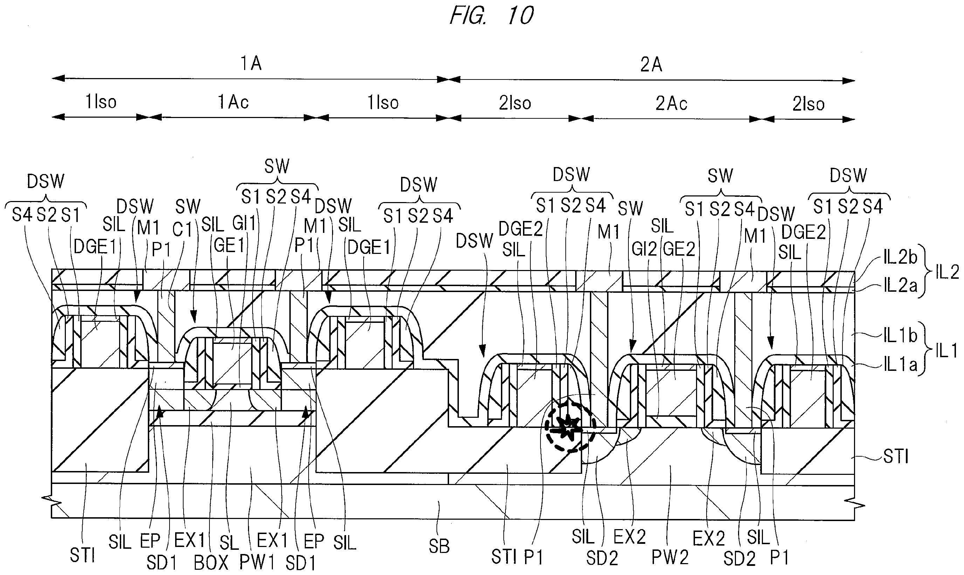

FIG. 10 is a cross-sectional view illustrating a configuration of a semiconductor device according to a fourth comparative example. As illustrated in FIG. 10, when a dummy gate electrode DGE2 and a dummy sidewall film DSW are provided on the element isolation regions 2Iso on both sides of an active region 2Ac in the bulk region 2A, the dummy sidewall film DSW can be destroyed by the charging damage (see a portion enclosed by a broken-line circle).

On the other hand, in the present application example, the dummy gate electrode DGE2 and the dummy sidewall film DSW are not provided on the element isolation regions 2Iso on both sides of the active region 2Ac in the bulk region 2A as illustrated in FIG. 8. Therefore, there is no charging damage. In order to reduce the influence of the charging damage, a distance (the shortest distance) from the dummy gate electrode DGE2 to a boundary between the active region 2Ac and the element isolation region 2Iso can be ensured to be large. However, in such a case, the failure due to the shift of the plug P1 cannot be eventually solved. Further, this prevents the downsizing and the high integration of the semiconductor device. On the other hand, in the present application example, such a failure can be avoided.

### [Description of Manufacturing Method]

Then, processes for manufacturing the semiconductor device according to the present embodiment will be described with reference to FIGs. 11 to 28, and the configuration of the semiconductor device according to the present embodiment will be made clearer. FIGs. 11 to 28 are cross-sectional views illustrating the processes for manufacturing the semiconductor device according to the first embodiment. Note that the semiconductor device illustrated in FIG. 1 is similar to the left of the semiconductor device in the application example illustrated in FIG. 8, and can be formed in similar manufacturing processes. Therefore, the manufacturing processes will be described using the semiconductor device in the application example illustrated in FIG. 8 as an example.

As illustrated in FIG. 11, an SOI substrate is prepared as a substrate. The SOI substrate is formed of a support substrate SB, an insulating layer BOX formed on the support substrate SB, and a semiconductor layer SL formed on the insulating layer BOX.

The support substrate SB is a semiconductor substrate made of, for example, single crystalline silicon (Si), and the insulating layer BOX is a layer made of silicon oxide. The semiconductor layer SL is a layer made of single crystalline silicon. The thickness of the insulating layer BOX is, for example, about 10 nm to 30 nm. The thickness of the semiconductor layer SL is, for example, about 10 nm to 30 nm.

While a method for forming the SOI substrate is not limited, the SOI substrate can be formed by using, for example, a bonding method. For example, after a single crystalline silicon substrate whose surface is subjected to thermal oxidization to form a silicon oxide film thereon and another single crystalline silicon substrate are bonded and stuck to each other by applying high temperature and pressure thereto, one of the single crystalline silicon substrates is polished and thinned. In this case, the thinned single crystalline silicon substrate becomes the semiconductor layer SL, the silicon oxide film becomes the insulating layer BOX, and the other single crystalline silicon substrate becomes the support substrate SB. In addition, the SOI substrate may be formed by using an SIMOX (Silicon Implanted Oxide) method. For example, O₂ (oxygen) is ion-implanted into a position slightly deeper than a surface of the single crystalline silicon substrate with high energy, and then, a heat treatment is performed to couple silicon and oxygen, so that the insulating layer (silicon oxide film) BOX is formed. In this case, an upper portion than the insulating layer BOX becomes the semiconductor layer SL, and a lower portion than the insulating layer BOX becomes the support substrate SB.

Then, as illustrated in FIG. 12, an element isolation insulating film STI is formed. For example, a hard mask (not illustrated) formed of a silicon nitride film or others is formed on regions which are left as the active regions 1Ac and 2Ac, and dry etching is performed while using the hard mask as a mask, so that parts of the semiconductor layer SL, the insulating layer BOX, and the support substrate SB are removed to form an element isolation trench. Note that etching of a lower-layer film while using a film having a desired shape as a mask is referred to as patterning. The element isolation trench penetrates the semiconductor layer SL and the insulating layer BOX, and reaches the middle of the support substrate SB. In other words, the bottom of the element isolation trench is at a position deeper than a bottom surface (bottom) of the insulating layer BOX.

Then, an insulating film is formed on the element isolation trench and the hard mask to have a thickness enough to fill the element isolation trench. For example, a silicon oxide film is deposited as an insulating film by using a CVD (Chemical Vapor Deposition) method or others.

Then, an insulating film other than the element isolation trench is removed by using a CMP (Chemical Mechanical Polishing) method, an etch-back method, or others until the hard mask is exposed. Thus, the element isolation insulating film STI having the element isolation trench in which the insulating film is embedded can be formed. The element isolation insulating film STI is formed in order to prevent an interference between MISFETs respectively formed in the SOI region 1A and the bulk region 2A. Then, the above-described hard mask is removed.

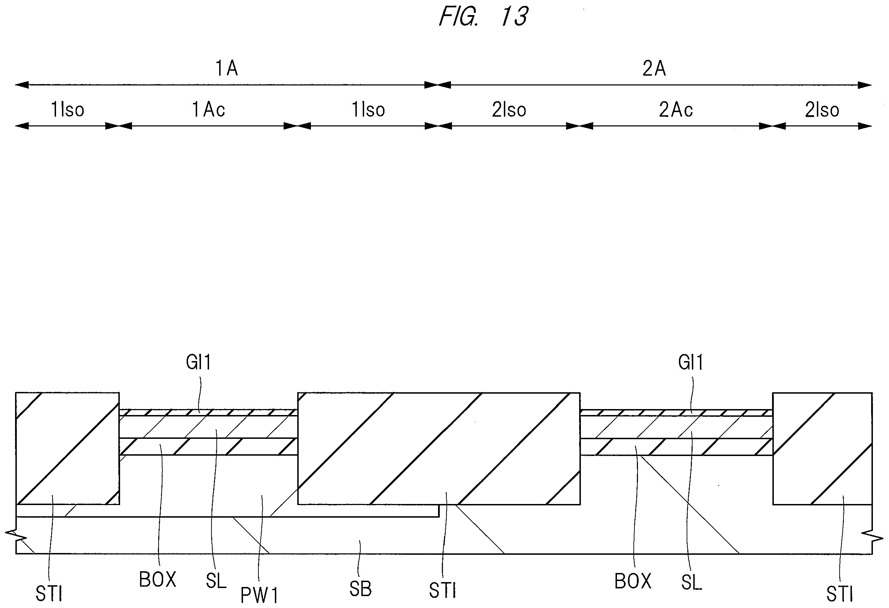

Then, as illustrated in FIG. 13, impurities for threshold value adjustment are implanted. In the SOI region 1A, p-type or n-type impurities are ion-implanted into the support substrate SB below the insulating layer BOX. Here, for example, p-type impurities are implanted into the lower portion of the insulating layer BOX while using a photoresist film (not illustrated) from which the SOI region 1A is opened as a mask, so that a p-type well PW1 is formed. Then, the photoresist film is removed by ashing processing or others.

Then, a gate insulating film GI1 in an SOI-MISFET formed in the SOI region 1A is formed. For example, an upper surface of a semiconductor layer (single crystalline silicon) SL is thermally oxidized, the gate insulating film GI1 formed of a silicon oxide film is formed. In this case, a silicon oxide film (a gate insulating film GI1) is also formed in the bulk region 2A.

Then, as illustrated in FIG. 14, the gate insulating film GI1, the semiconductor layer SL, the insulating layer BOX, and others in the bulk region 2A are removed. For example, the gate insulating film GI1, the semiconductor layer SL, and the insulating layer BOX in the bulk region 2A are etched while using a photoresist film (not illustrated) from which the bulk region 2A is opened as a mask. Then, the photoresist film is removed by ashing processing or others.

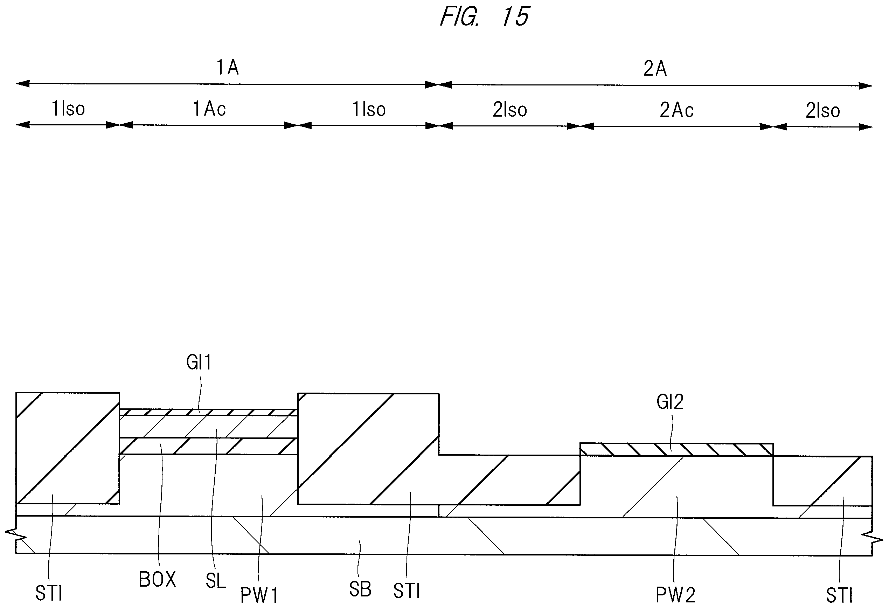

Then, as illustrated in FIG. 15, p-type impurities are ion-implanted into the support substrate SB in the bulk region 2A, so that a p-type well PW2 is formed. Here, for example, p-type impurities are implanted into the support substrate SB while using a photoresist film (not illustrated) from which the bulk region 2A is opened as a mask, so that the p-type well PW2 is formed. Then, the photoresist film is removed by ashing processing or others.

Then, a gate insulating film GI2 in a bulk MISFET formed in the bulk region 2A is formed. For example, an upper surface of the support substrate SB is thermally oxidized, so that the gate insulating film GI2 formed of a silicon oxide film is formed. In this case, the SOI region 1A may be covered with a mask film (e.g., a silicon nitride film) so that the gate insulating film GI1 in the SOI region 1A does not thicken.

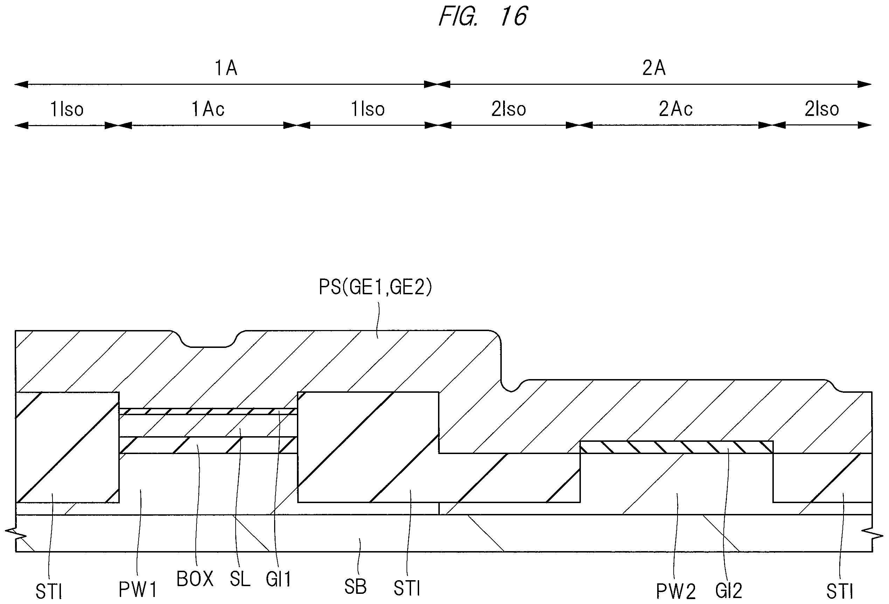

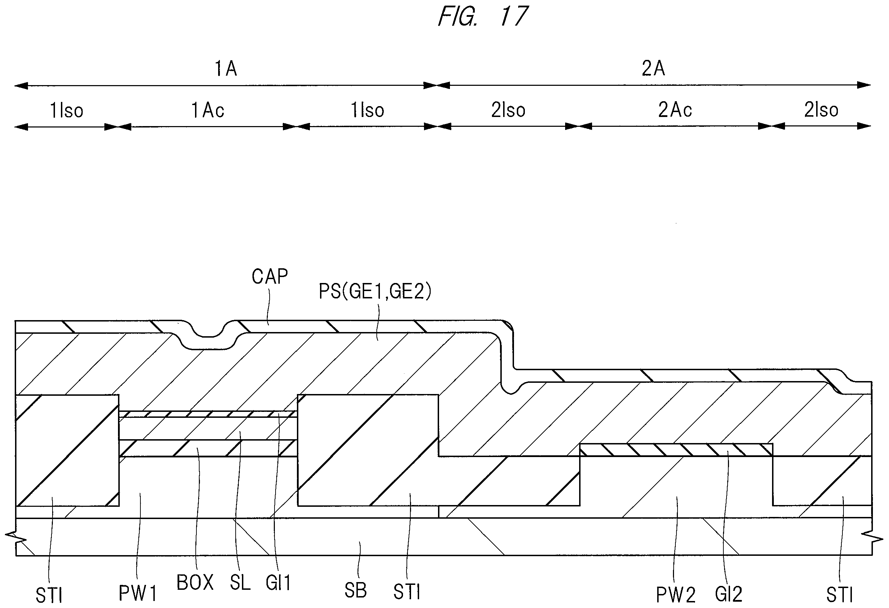

Then, as illustrated in FIG. 16, in the SOI region 1A and the bulk region 2A, a conductive film to be a gate electrode is formed. For example, a polycrystalline silicon film PS is formed as a conductive film by using a CVD method or others. Then, as illustrated in FIG. 17, a cap insulating film CAP is formed on the conductive film. For example, on the polycrystalline silicon film PS, a silicon nitride film is formed as the cap insulating film CAP by using a CVD method or others.

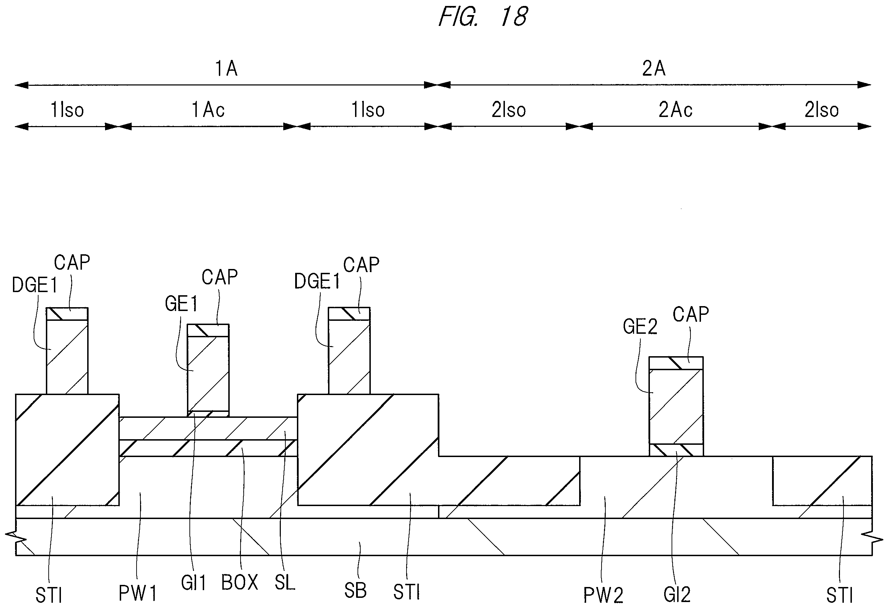

Then, as illustrated in FIG. 18, the polycrystalline silicon film PS and the cap insulating film CAP are patterned. For example, a photoresist film (not illustrated) is formed on the cap insulating film CAP, and is exposed and developed, so that the photoresist film in regions other than the regions where the gate electrodes GE1 and GE2 are formed is removed. Then, the cap insulating film CAP is etched while using the photoresist film as a mask. Then, the photoresist film (not illustrated) is removed by an ashing processing or others, and the polycrystalline silicon film PS is etched while using the cap insulating film CAP as a mask, so that the gate electrode GE1 and GE2 are formed in the SOI region 1A and the bulk region 2A. In this case, a dummy gate electrode DGE1 is formed on the element isolation region 1Iso in the SOI region 1A. The dummy gate electrode DGE1 is formed along a boundary between the active region 1Ac and the element isolation region 1Iso. More preferably, the dummy gate electrode DGE1 is formed in a consideration of such a length of the dummy sidewall film DSW described below in the gate length direction as matching an end of the dummy sidewall film DSW with the boundary between the active region 1Ac and the element isolation region 1Iso or as overlapping (covering) the dummy sidewall film DSW with the boundary between the active region 1Ac and the element isolation region 1Iso.

Then, a source/drain region in each of the SOI-MISFET and the bulk MISFET is formed.

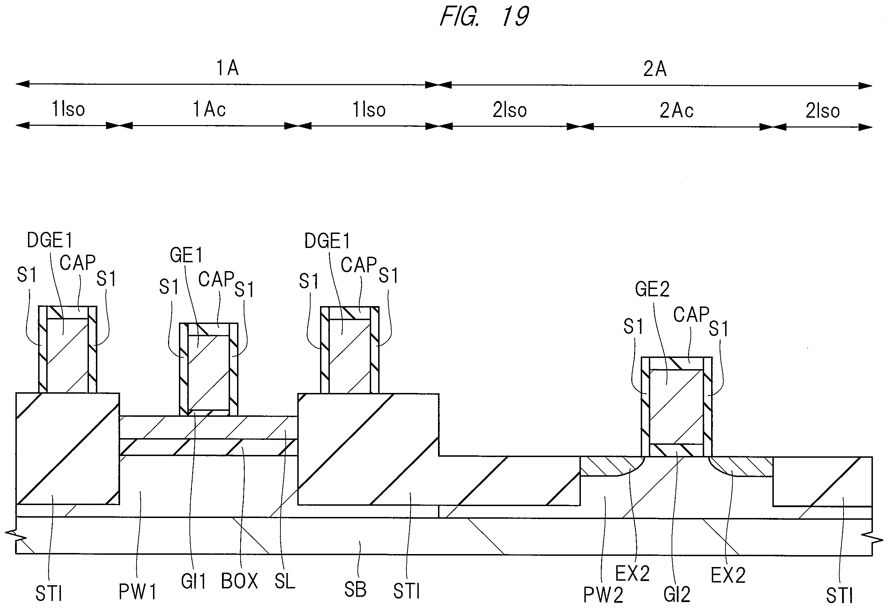

First, as illustrated in FIG. 19, a first film (also referred to as a first sidewall film or an offset spacer) S1 is formed on a sidewall of the gate electrode GE2, and an n-type low-concentration impurity region EX2 is formed in the support substrate (the p-type well PW2) SB on both sides of the gate electrode GE2.

For example, in the SOI region 1A and the bulk region 2A, a silicon oxide film is deposited as an insulating film serving as the first film S1 by using, for example, a CVD method, and then, anisotropic etching is performed, so that the first film S1 is left as sidewall films on respective sidewalls of the gate electrodes GE1 and GE2. In this case, the first film S1 is also left as a sidewall film on a sidewall of the dummy gate electrode DGE1.

Then, in the bulk region 2A, the n-type low-concentration impurity region EX2 is formed in the support substrate (the p-type well PW2) SB on both sides of a composite of the gate electrode GE2 and the first film S1. For example, the SOI region 1A is covered with a photoresist film (not illustrated), and n-type impurities are introduced into the support substrate (the p-type well PW2) SB by an ion implantation method while using the composite of the gate electrode GE2 and the first film S1 as a mask. Then, the photoresist film (not illustrated) is removed by an ashing processing or others.

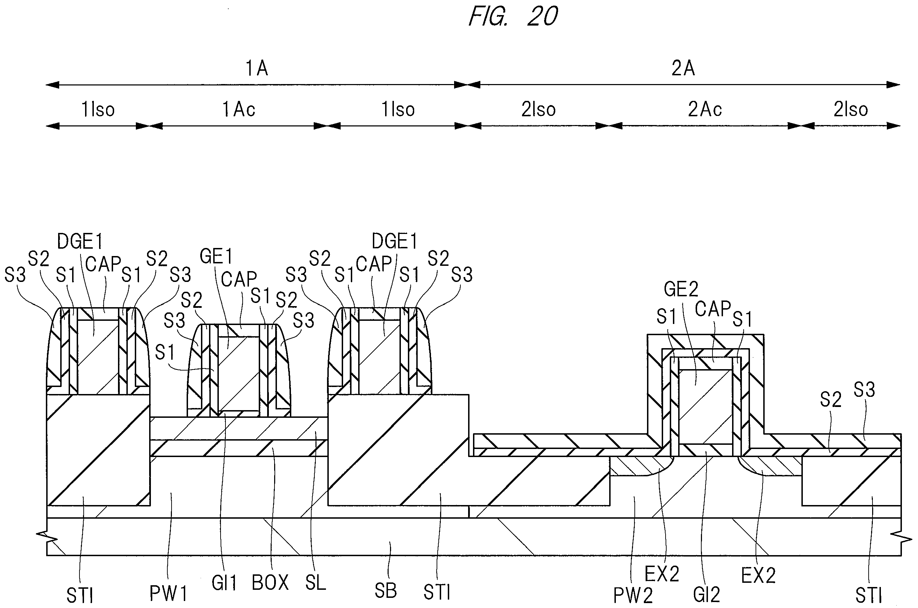

Then, as illustrated in FIGs. 20 and 21, a sidewall film formed of the first film S1, a second film (second sidewall film) S2, and a third film (third sidewall film) S3 is formed on the sidewall of the gate electrode GE1 (see FIG. 20), and an epitaxial layer EP is formed on the semiconductor layer SL (see FIG. 21).

In the SOI region 1A and the bulk region 2A, a silicon nitride film and a silicon oxide film are sequentially deposited respectively as insulating films to be the second film S2 and the third film S3 by using, for example, a CVD method. Then, the bulk region 2A is covered with a photoresist film (not illustrated), and anisotropic etching is performed, so that the second film S2 and the third film S3 are left as sidewall films on a sidewall of the composite of the gate electrode GE1 and the first film S1. In this case, the second film S2 and the third film S3 are also left on the sidewall of the composite of the dummy gate electrode DGE1 and the first film S1. Thus, a sidewall film formed of the first film S1, the second film S2, and the third film S3 is formed on the sidewall of each of the gate electrode GE1 and the dummy gate electrode DGE1. Then, the photoresist film (not illustrated) is removed by an ashing processing or others. In the anisotropic etching, note that the bulk region 2A is covered with a photoresist film (not illustrated), and therefore, a stacked film of the second film S2 and the third film S3 is left to cover the bulk region 2A. Thus, an upper surface of the semiconductor layer SL is exposed on both sides of a composite of the gate electrode GE1 and the sidewall film (S1, S2, S3) in the SOI region 1A, and the bulk region 2A is covered with the stacked film of the second film S2 and the third film S3.

Then, the epitaxial layer EP is formed on the semiconductor layer SL exposed on both sides of the composite of the gate electrode GE1 and the sidewall film (S1, S2, S3) (see FIG. 21). For example, a silicon layer is formed as the semiconductor layer SL by epitaxial growth using dichlorosilane (SiH₂Cl₂) and hydrogen chloride (HCl) gas. Then, an oxide film OX is formed on the epitaxial layer EP. For example, an upper surface of the epitaxial layer EP is thermally oxidized, so that a silicon oxide film (the oxide film OX) is formed.

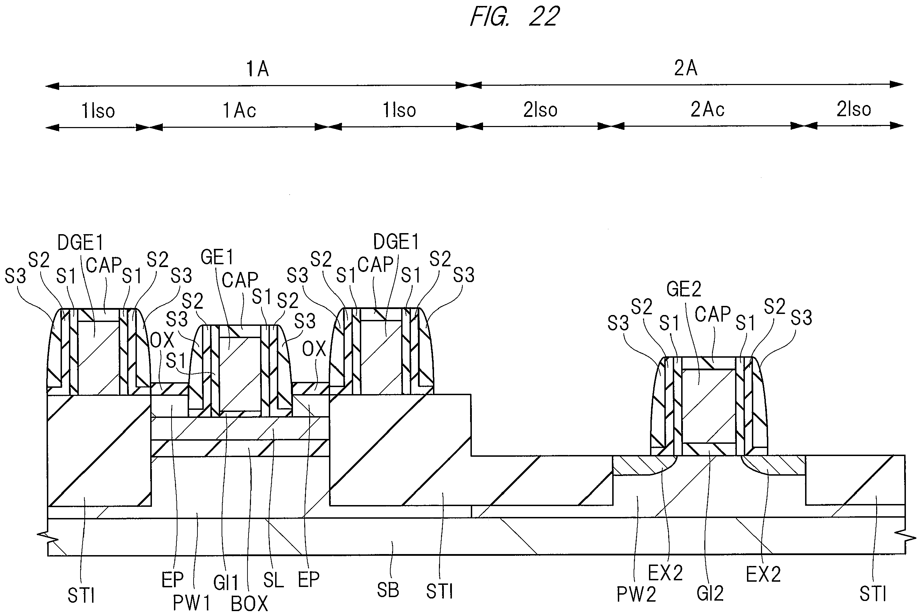

Then, as illustrated in FIG. 22, the sidewall film formed of the first film S1, the second film S2, and the third film S3 is formed on a sidewall of the gate electrode GE2. For example, the SOI region 1A is covered with a photoresist film (not illustrated), and the second film S2 and the third film S3 are subjected to anisotropic etching, so that the second film S2 and the third film S3 are left as the sidewall films on the sidewall of the composite of the gate electrode GE2 and the first film S1. Thus, the sidewall film formed of the first film S1, the second film S2, and the third film S3 is formed on the sidewall of the gate electrode GE2. Then, the photoresist film (not illustrated) is removed by an ashing processing or others.

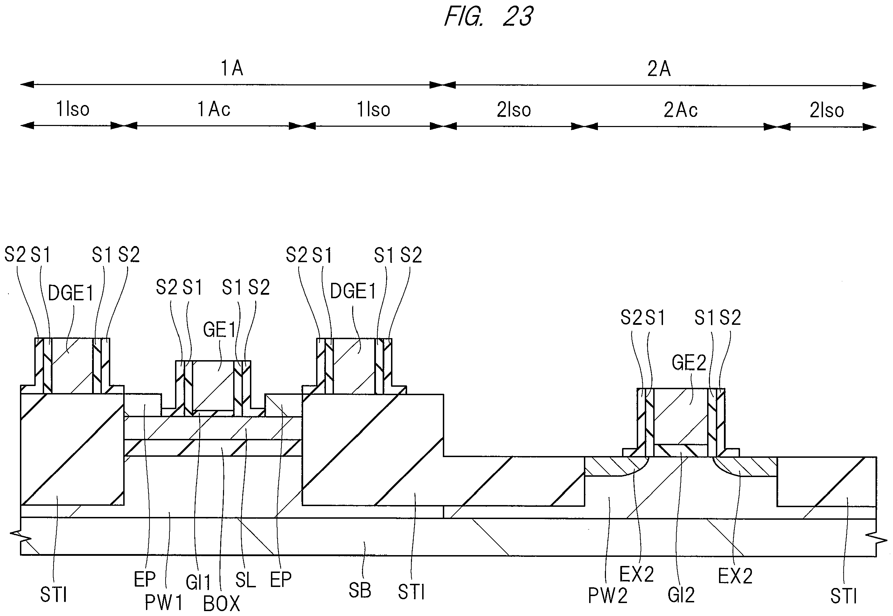

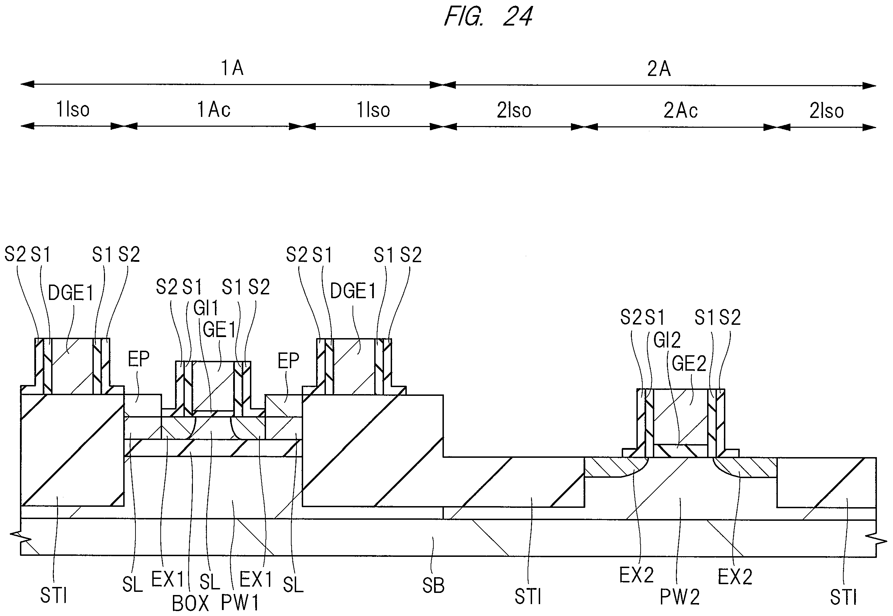

Then, as illustrated in FIGs. 23 and 24, the third film S3 on the sidewall of each of the gate electrodes GE1 and GE2 and the oxide film OX are removed, and the cap insulating film (silicon nitride film) CAP on each of the gate electrodes GE1 and GE2 is further removed (see FIG. 23). Then, an n-type low-concentration impurity region EX1 is formed in the semiconductor layer SL on both sides of the gate electrode GE1.

For example, the bulk region 2A is covered with a photoresist film (not illustrated), and n-type impurities are introduced into the semiconductor layer SL by an ion implantation method while using a composite of the gate electrode GE1, the first film S1, and the second film S2 as a mask. In this case, an n-type low-concentration impurity region (not illustrated) is also formed in an upper portion of the epitaxial layer EP. Then, the photoresist film (not illustrated) is removed by an ashing processing or others.

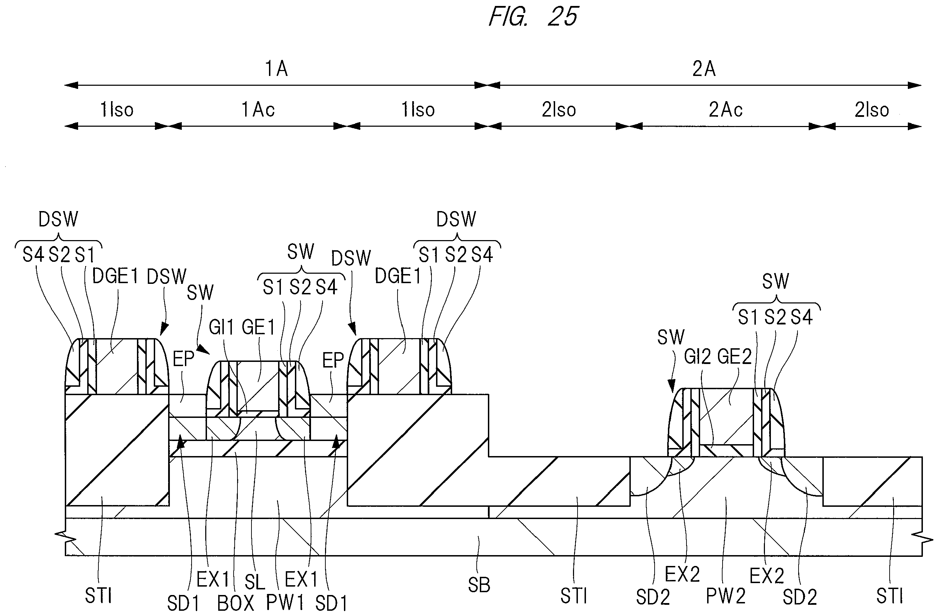

Then, as illustrated in FIG. 25, a fourth film (fourth sidewall film) S4 serving as a sidewall film of each of the gate electrodes GE1 and GE2 is formed, and an n-type high-concentration impurity region SD1 is formed in the epitaxial layer EP on both sides of the gate electrode GE1 and the semiconductor layer SL which is the layer below the epitaxial layer EP. An n-type high-concentration impurity region SD2 is formed in the support substrate (the p-type well PW2) SB on both sides of the gate electrode GE2.

For example, in the SOI region 1A and the bulk region 2A, a silicon oxide film is deposited as an insulating film serving as a fourth film S4 by using, for example, a CVD method, and anisotropic etching is performed, so that the fourth film S4 is left as a sidewall film on a sidewall of the composite of the gate electrode GE1, the first film S1, and the second film S2. Similarly, the fourth film S4 is left as a sidewall film on a sidewall of a composite of the gate electrode GE2, the first film S1, and the second film S2. In this case, the fourth film S4 is also left on a sidewall of a composite of the dummy gate electrode DGE1, the first film S1, and the second film S2. Thus, a dummy sidewall film DSW formed of the first film S1, the second film S2, and the fourth film S4 is formed on a sidewall of each of the gate electrodes GE1 and GE2 and the dummy gate electrode DGE1.

Then, n-type impurities are introduced into the epitaxial layer EP and the semiconductor layer SL which is the layer below the epitaxial layer EP by an ion implantation method while using a composite of the gate electrode GE1 and the sidewall film (S1, S2, S4) as a mask, so that an n-type high-concentration impurity region SD1 is formed. And, the n-type impurities are introduced into the support substrate (the p-type well PW2) SB by an ion implantation method while using a composite of the gate electrode GE2 and the sidewall film (S1, S2, S4) as a mask, so that an n-type high-concentration impurity region SD2 is formed. The concentrations of the n-type high-concentration impurity regions SD1 and SD2 may be different from each other.

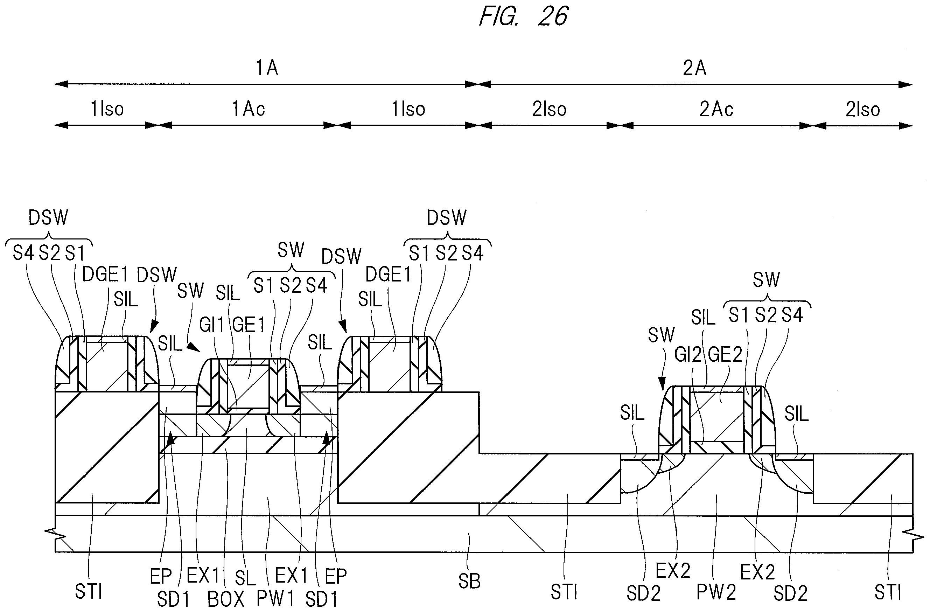

Then, as illustrated in FIG. 26, a metal silicide layer SIL is formed on each of the gate electrodes GE1 and GE2, the dummy gate electrode DGE1, and the n-type high-concentration impurity regions SD1 and SD2 by using a Salicide (Self Aligned Silicide) technique. Here, for example, a nickel silicide film is formed as the metal silicide layer SIL. For example, in the SOI region 1A and the bulk region 2A, a metal film such as a nickel (Ni) film is formed, and is subjected to heat treatment. In this manner, silicidation reaction is caused in a contact region between the Ni film and each of the gate electrodes GE1 and GE2 and the dummy gate electrode DGE1 and a contact region between the Ni film and each of the n-type high-concentration impurity regions SD1 and SD2. Then, the unreacted Ni film is removed, so that the nickel silicide film is formed.

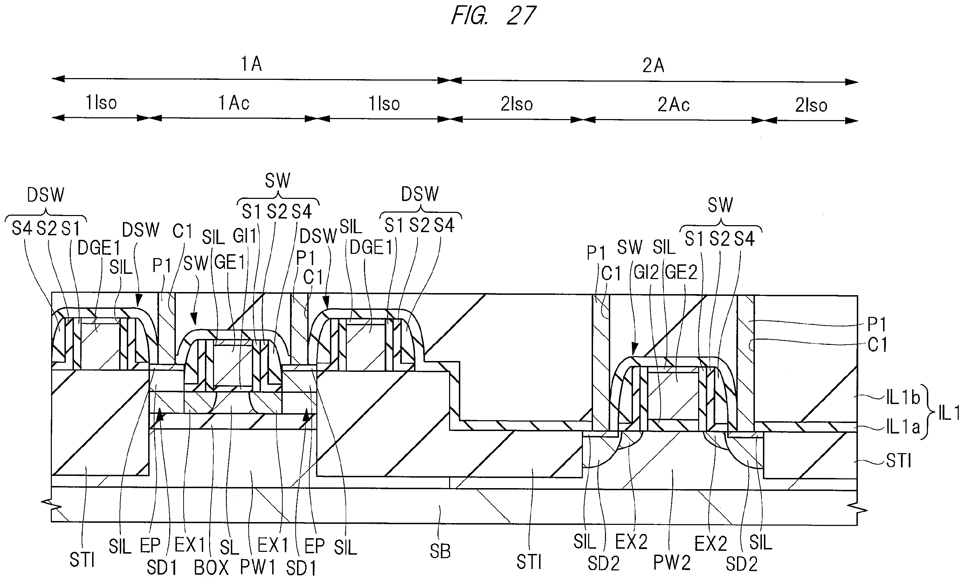

Then, as illustrated in FIG. 27, in the SOI region 1A and the bulk region 2A, an interlayer insulating film IL1 and a plug P1 are formed. First, in the SOI region 1A and the bulk region 2A, a stacked film of a thin silicon nitride film ILla and a silicon oxide film IL1b is formed as the interlayer insulating film IL1 by using a CVD method or others.

Then, the interlayer insulating film IL1 is patterned, so that a contact hole C1 is formed. For example, in the case of the patterning, a formation position of the contact hole C1 is shifted by shift in overlapping between the transferring photomask and an SOI substrate (wafer) in some cases (see FIG. 4). Then, a stacked film of a barrier film (not illustrated) and a metal film is deposited as a conductive film on the interlayer insulating film IL1 including the inside of the contact hole C1. Then, the deposited conductive film, excluding the contact hole C1, is removed by using a CMP method or others. The conductive film is embedded in the contact hole C1 as described above, so that the plug P1 is formed.

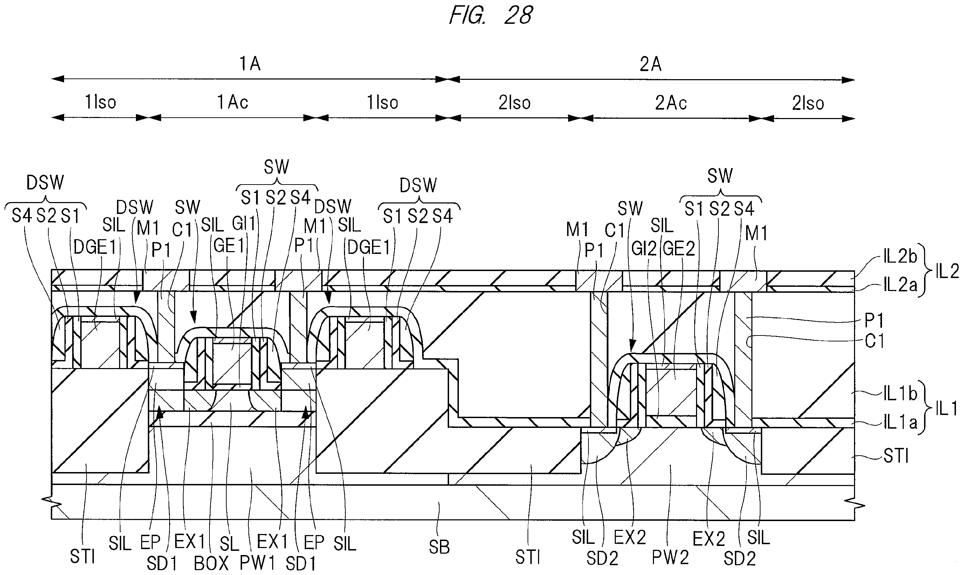

As illustrated in FIG. 28, a wiring M1 is formed on the interlayer insulating film IL1 including the upper portion of the plug P1. For example, a stacked film of a thin silicon nitride film IL2a and a silicon oxide film IL2b is formed on the interlayer insulating film IL1 including the upper portion of the plug P1 as an interlayer insulating film (an insulating film for a wiring trench) IL2 by using a CVD method or others. Then, the interlayer insulating film IL2 is patterned to form a wiring trench, a conductive film such as a copper film is deposited on the interlayer insulating film IL2 including the inside of the wiring trench, and the deposited conductive film, excluding the wiring trench, is removed by using a CMP method or others. Thus, the conductive film is embedded in the wiring trench, so that the wiring M1 is formed (by a damascene method) . Note that the wiring M1 may be formed by patterning. For example, a conductive film such as an Al film is deposited on the interlayer insulating film IL1, and is patterned, so that the wiring M1 is formed. Then, a multilayer wiring may be further formed by repeatedly forming an interlayer insulating film, a plug, and a wiring.

### (Second Embodiment)

In the present embodiment, a modification example of the semiconductor device according to the first embodiment will be described.

### (First Modification Example)

As described with reference to FIG. 2 in the first embodiment, the composite (hereinafter, also referred to as a dummy pattern) of the dummy gate electrode DGE1 and the dummy sidewall film DSW is formed so as to extend in the Y-direction between the two active regions 1Ac arranged side by side in the X-direction. However, the dummy pattern may also be extended in the X-direction.

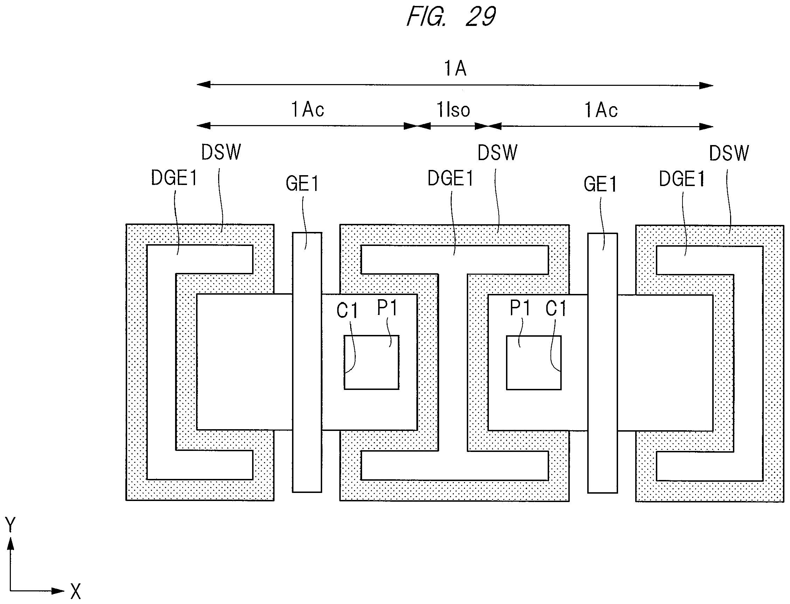

FIG. 29 is a plan view illustrating a configuration of a semiconductor device in the first modification example of the present embodiment. As illustrated in FIG. 29, the semiconductor device in the present modification example includes a first dummy pattern including a first portion (longitudinal portion) extending in a Y-direction between two active regions 1Ac arranged side by side in an X-direction and a second portion (lateral portion) extending in the X-direction on both ends of the first portion. The first dummy pattern can be said to have a substantially "I" shape.

The semiconductor device in the present modification example includes a second dummy pattern including a third portion (longitudinal portion) extending in the Y-direction along the left side (a boundary) of the active region 1Ac arranged on the left side in the drawing among the two active regions 1Ac arranged side by side in the X-direction and a fourth portion (lateral portion) extending in the X-direction on both ends of the third portion. The second dummy pattern can also be said to have a substantially "U" shape.

The semiconductor device in the present modification example includes a third dummy pattern including a fifth portion (longitudinal portion) extending in the Y-direction along the right side (a boundary) of the active region 1Ac arranged on the right side in the drawing among the two active regions 1Ac arranged side by side in the X-direction and a sixth portion (lateral portion) extending in the X-direction on both ends of the fifth portion. The third dummy pattern can also be said to have a substantially "U" shape.

Thus, in the present modification example, by the arrangement of the longitudinal portions and the lateral portions, the respective outer peripheries of the two active regions 1Ac can be almost surrounded by the dummy patterns. Therefore, even if the plug P1 shifts in any direction, the failure due to the shift can be solved. And, the failure due to the hollow portion (recess or STI divot) occurring along the boundary between the active region 1Ac and the element isolation region 1Iso can be solved. As a result, further improvements in the characteristics of the semiconductor device such as the decrease in the leakage current and the improvement in the TDDB life can be achieved.

For a method for manufacturing the semiconductor device in the present modification example, note that the semiconductor device can be formed by using manufacturing processes similar to the manufacturing processes described in the first embodiment.

### (Second Modification Example)

As described with reference to FIG. 2 in the first embodiment, one dummy pattern is formed to extend in the Y-direction between the two active regions 1Ac arranged side by side in the X-direction. However, two dummy patterns may be provided.

For example, if the distance in the X-direction between the two active regions 1Ac arranged side by side in the X-direction is large, two dummy patterns may be provided.

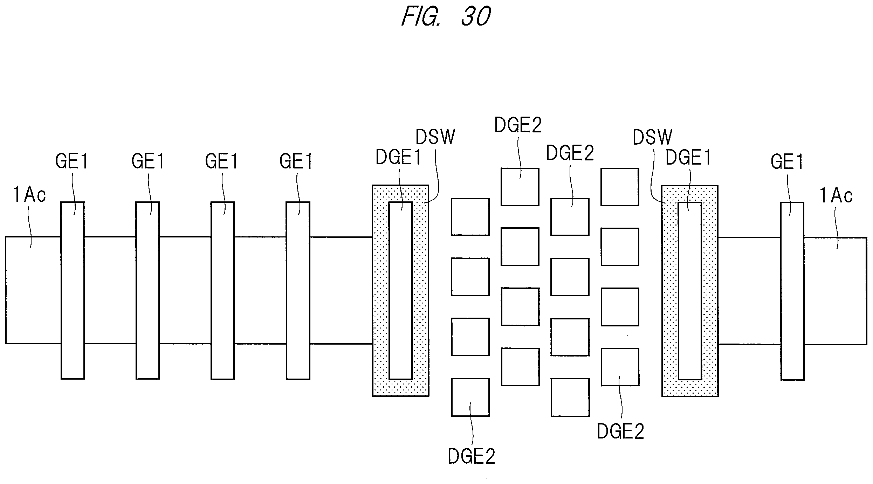

FIG. 30 is a plan view illustrating a configuration of a semiconductor device in a second modification example of the present embodiment. As illustrated in FIG. 30, in the semiconductor device in the present modification example, two dummy patterns extending in a Y-direction with a predetermined distance therebetween are arranged between two active regions 1Ac arranged side by side in an X-direction. In this case, for example, the first dummy pattern is arranged to extend in the Y-direction along the right side of the active region 1Ac arranged on the left side in the drawing out of the two active regions 1Ac arranged side by side in the X-direction, and the second dummy pattern is arranged to extend in the Y-direction along the left side of the active region 1Ac arranged on the right side in the drawing.

Furthermore, if the distance between the two dummy patterns is large, a dummy gate electrode DGE2 may be provided as illustrated. A planar shape of the dummy gate electrode DGE2 is a different shape from a planar shape of the dummy gate electrode DGE1. For example, the planar shape of the dummy gate electrode DGE1 is a line shape extending in the Y-direction while the planar shape of the dummy gate electrode DGE2 is a rectangular shape (a substantially square shape). A plurality of the rectangular dummy gate electrodes DGE2 are arranged with a predetermined distance therebetween in the X-direction and the Y-direction. That is, a plurality of dummy gate electrodes DGE2 having a smaller shape and having a smaller plane area than those of the dummy gate electrode DGE1 are arranged. The plurality of dummy gate electrode DGE2 are, for example, automatic generation dummy gate electrodes automatically laid out in a region where a gate electrode or others is not formed in a design tool. Thus, by the arrangement of the automatic generation dummy gate electrode DGE2 between the dummy gate electrodes DGE1, a difference in the number of the gate electrodes or others is reduced, so that a processing accuracy in the manufacturing processes of the semiconductor device is improved. For example, flatness of a layer formed to be upper than the gate electrode is improved, so that failures due to an exposure failure or dishing can be reduced.

For a method for manufacturing the semiconductor device in the present modification example, note that the semiconductor device can be formed in the manufacturing processes similar to the manufacturing processes described in the first embodiment.

### (Third Modification Example)

The second modification example has described the case in which the distance in the X-direction between the two active regions 1Ac is large. The present modification example will describe a case in which the distance in an X-direction between the two active regions 1Ac is small.

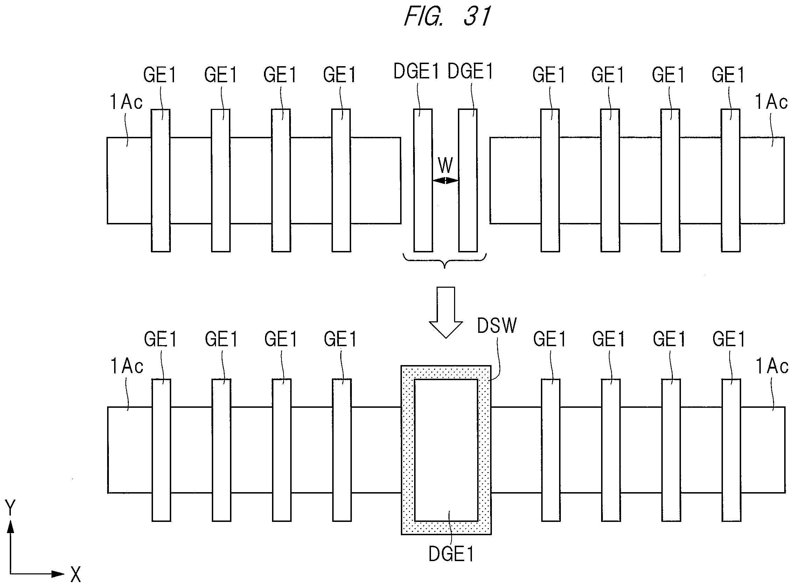

FIG. 31 is a plan view illustrating a configuration of a semiconductor device in a third modification example of the present embodiment. As illustrated in an upper diagram of FIG. 31, in the semiconductor device in the present modification example, two dummy gate electrodes DGE1 extending in a Y-direction with a predetermined space therebetween are arranged between two active regions 1Ac arranged side by side in an X-direction. In such a case, if the distance "W" in the X-direction therebetween is smaller than, for example, two times the length in the gate length direction (the length in the X-direction) of the sidewall film SW formed on one side of the gate electrode GE1, the dummy sidewall films DSW unfavorably overlap each other.

If a distance from a boundary between the active region 1Ac and the element isolation insulating film STI to the gate electrode GE1 is smaller than two times the length in the gate length direction (the length in the X-direction) of the sidewall film SW, there is a risk in which an entire surface of the epitaxial layer EP is covered with the sidewall film SW and the dummy sidewall film DSW. That is, there is a risk of impossibility of securement of a space where the plug P1 contacts the epitaxial layer EP. Therefore, it is required to adjust a position of the dummy gate electrode DGE1 so that the epitaxial layer EP is exposed from the sidewall film SW and the dummy sidewall film DSW. For example, when the width of the element isolation insulating film STI is narrow and when the space to form the two dummy gate electrodes DGE1 is not sufficiently large, if the two dummy gate electrodes DGE1 are forcibly arranged, the dummy gate electrodes DGE1 are forced to be arranged at positions significantly close to the boundary between the active region 1Ac and the element isolation insulating film STI. Therefore, the above-described failures are easy to occur.

Accordingly, as illustrated in a lower diagram of FIG. 31, in the semiconductor device in the present modification example, one dummy gate electrode DGE1 extending in the Y-direction and being thick, i.e., having a large length in the gate length direction (length in the X-direction) is arranged between the two active regions 1Ac arranged side by side in the X-direction. In this case, for example, the length in the gate length direction (the length in the X-direction) of the dummy gate electrode DGE1 is larger than the length in the gate length direction (the length in the X-direction) of the gate electrode GE1.

If the width of the element isolation insulating film STI is significantly narrow, the length of the dummy gate electrode DGE1 may be smaller than the length of the gate electrode GE1 in the length in the gate length direction (the length in the X-direction) . Thus, the length in the gate length direction (the length in the X-direction) of the dummy gate electrode DGE1 may be made different from the length in the gate length direction (the length in the X-direction) of the gate electrode GE1.

For a method for manufacturing the semiconductor device in the present modification example, note that the semiconductor device can be formed in the manufacturing processes similar to the manufacturing processes described in the first embodiment.

### (Fourth Modification Example)

The first embodiment (FIGs. 1 and 8) has exemplified the n-channel MISFET as the MISFET in the SOI region 1A and the n-channel MISFET as the MISFET in the bulk region 2A. However, of course, p-channel MISFETs may be formed in these regions. In this case, each conductivity type of the wells (PW1 and PW2), the low-concentration impurity regions (EX1 and EX2), and the high-concentration impurity regions (SD1 and SD2) becomes an opposite conductivity type.

In the SOI region 1A, an n-channel MISFET and a p-channel MISFET may be formed. In the bulk region 2A, an n-channel MISFET and a p-channel MISFET may be formed. For example, a logic circuit (a standard cell) can be configured by appropriately connecting a plurality of n-channel MISFETs and a plurality of p-channel MISFETs in the SOI region 1A.

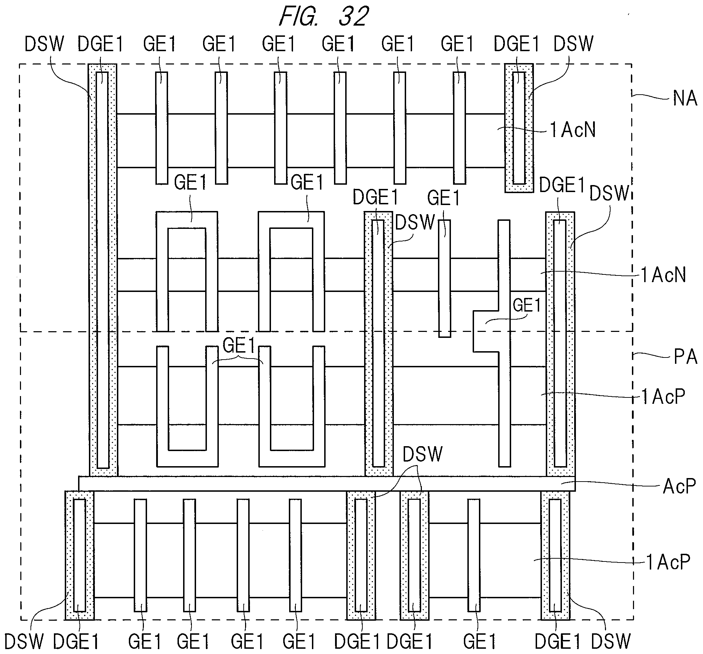

FIG. 32 is a plan view illustrating an example of a configuration of a semiconductor device in a fourth modification example of the present embodiment. FIG. 32 illustrates an SOI region 1A. As illustrated in FIG. 32, the SOI region (1A) includes an n-channel MISFET formation region NA and a p-channel MISFET formation region PA. In the n-channel MISFET formation region NA, a p-type well (PW1) containing p-type impurities is arranged in a support substrate SB below a semiconductor layer SL. In the p-channel MISFET formation region PA, an n-type well containing n-type impurities is arranged in a support substrate SB below a semiconductor layer SL.

In the n-channel MISFET formation region NA, three active regions 1AcN are provided. Among the active regions and on respective ends of the active regions, a dummy pattern is arranged to extend in a Y-direction.

In the p-channel MISFET formation region PA, four active regions 1AcP are provided. Among the active regions and at respective ends of the active regions, a dummy pattern is arranged to extend in the Y-direction.

Here, one dummy pattern may be arranged over the n-channel MISFET formation region NA and the p-channel MISFET formation region PA. That is, one dummy pattern is arranged to extend over both upper portions of the p-type well (PW1) where the n-channel MISFET is formed and the n-type well where the p-channel MISFET is formed. Thus, the dummy gate electrode DGE1 may be shared between the region NA and the region PA.

In the foregoing, the invention made by the present inventor has been concretely described based on the embodiments. However, it is needless to say that the present invention is not limited to the foregoing embodiments and various modifications and alterations can be made within the scope of the present invention.

For example, the lateral portion described in the first modification example may be provided in the dummy pattern in the second modification example.

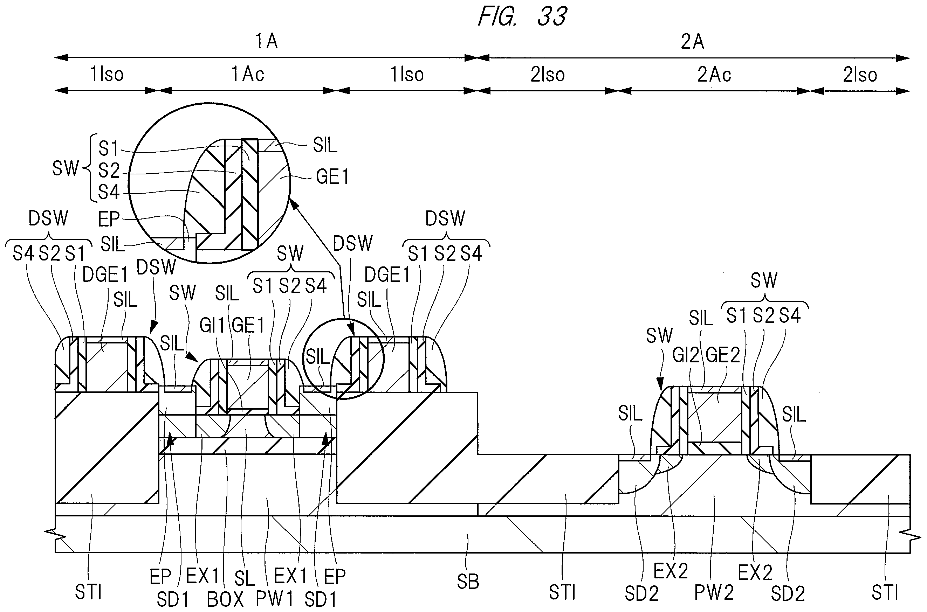

FIG. 33 is a cross-sectional view illustrating a configuration of a semiconductor device in another modification example. For example, in the first embodiment (FIGs. 1 and 8), the third film S3 is removed, and the epitaxial layer EP is formed, and then, the fourth film S4 is formed. Therefore, for example, as illustrated in FIG. 33, the fourth film S4 may extend to the upper portion of the epitaxial layer EP. That is, an end of the dummy sidewall film DSW is positioned on the epitaxial layer EP. Thus, even if misalignment in matching has occurred when the plug P1 is formed, such a failure that the plug P1 reaches the support substrate SB can be more effectively solved. The risk of the decrease in the breakdown voltage of the insulating layer BOX between the metal silicide layer SIL and the support substrate SB can be more effectively solved. Note that the example in FIG. 33 can also be used in not only the first embodiment but also combination with another modification example.

## Claims

1. A semiconductor device comprising:
an SOI substrate including a first active region (1Ac) and an element isolation region (1Iso) arranged in contact with the first active region, the SOI substrate including a support substrate, an insulating layer (BOX) formed on the support substrate, and a semiconductor layer formed on the insulating layer;
a gate electrode (GE1) formed on the semiconductor layer in the first active region via a gate insulating film (GI1);
a source/drain region (SD1) formed in the semiconductor layer on both sides of the gate electrode;
a dummy gate electrode (DGE1) formed in the element isolation region, and electrically isolated from the gate electrode; and
a sidewall film (DSW) formed on both sides of the dummy gate electrode,
wherein the element isolation region is comprised of an insulating film (STI) embedded in a trench deeper than the insulating layer, and
the sidewall film is arranged along a boundary between the first active region and the element isolation region.

2. The semiconductor device according to claim 1,
wherein the sidewall film is arranged to match or overlap the boundary between the first active region and the element isolation region.

3. The semiconductor device according to claim 2, further comprising
a contact plug formed on the source/drain region.

4. The semiconductor device according to claim 2,
wherein a surface of the insulating film is lower than a surface of the semiconductor layer at the boundary between the first active region and the element isolation region.

5. The semiconductor device according to claim 4, further comprising
a chemical compound film comprised of a semiconductor constituting the source/drain region and a metal is formed on a surface of the source/drain region.

6. The semiconductor device according to claim 5,
wherein the source/drain region is an impurity region formed in a stacked portion of the semiconductor layer and an epitaxial layer between the semiconductor layer and the chemical compound film.

7. The semiconductor device according to claim 6,
wherein an end of the sidewall film is positioned above the epitaxial layer.

8. The semiconductor device according to claim 2,
wherein the element isolation region includes:
a first outer peripheral portion positioned on an outer periphery of the first active region;
a second active region; and
a second outer peripheral portion positioned on an outer periphery of the second active region,
the insulating layer and the semiconductor layer are not arranged in the second active region, and
the dummy gate electrode is arranged in the first outer peripheral portion and is not arranged in the second outer peripheral portion.

## Patentansprüche

1. Halbleitervorrichtung, die Folgendes umfasst:
ein SOI-Substrat, das eine erste aktive Region (1Ac) und eine Elementisolationsregion (1Iso) umfasst, die in Kontakt mit der ersten aktiven Region angeordnet ist, wobei das SOI-Substrat ein Trägersubstrat, eine Isolationsschicht (BOX), die auf dem Trägersubstrat ausgebildet ist, und eine Halbleiterschicht, die auf der Isolationsschicht ausgebildet ist, umfasst;
eine Gate-Elektrode (GE1), die auf der Halbleiterschicht in der ersten aktiven Region mittels eines Gate-Isolationsfilms (GI1) ausgebildet ist;
eine Source/Drain-Region (SD1), die in der Halbleiterschicht auf beiden Seiten der Gate-Elektrode ausgebildet ist;
eine Dummy-Gate-Elektrode (DGE1), die in der Elementisolationsregion ausgebildet und gegenüber der Gate-Elektrode elektrisch isoliert ist; und
einen Seitenwandfilm (DSW), der auf beiden Seiten der Dummy-Gate-Elektrode ausgebildet ist,
wobei die Elementisolationsregion aus einem Isolationsfilm (STI) besteht, der in einen Graben eingebettet ist, der tiefer als die Isolationsschicht ist, und wobei
der Seitenwandfilm entlang einer Grenzfläche zwischen der ersten aktiven Region und der Elementisolationsregion angeordnet ist.

2. Halbleitervorrichtung nach Anspruch 1,
wobei der Seitenwandfilm angeordnet ist, um mit der Grenzfläche zwischen der ersten aktiven Region und der Elementisolationsregion übereinzustimmen oder diese zu überlappen.

3. Halbleitervorrichtung nach Anspruch 2, die ferner einen Kontaktanschluss umfasst, der in der Source/Drain-Region ausgebildet ist.

4. Halbleitervorrichtung nach Anspruch 2,
wobei an der Grenzfläche zwischen der ersten aktiven Region und der Elementisolationsregion eine Oberfläche des Isolationsfilms niedriger ist als eine Oberfläche der Halbleiterschicht.

5. Halbleitervorrichtung nach Anspruch 4, die ferner Folgendes umfasst:
einen Film aus einer chemischen Verbindung, der aus einem Halbleiter, der die Source/Drain-Region bildet, und einem Metall besteht, das auf einer Oberfläche der Source/Drain-Region ausgebildet ist.

6. Halbleitervorrichtung nach Anspruch 5,
wobei die Source/Drain-Region eine Verunreinigungsregion, die in einem gestapelten Abschnitt der Halbleiterschicht ausgebildet ist, und eine Epitaxialschicht zwischen der Halbleiterschicht und dem Film aus einer chemischen Verbindung ist.

7. Halbleitervorrichtung nach Anspruch 6,
wobei ein Ende des Seitenwandfilms oberhalb der Epitaxialschicht angeordnet ist.

8. Halbleitervorrichtung nach Anspruch 2,
wobei die Elementisolationsschicht Folgendes umfasst:
einen ersten Außenumfangsabschnitt, der auf einem Außenumfang der ersten aktiven Region angeordnet ist;
eine zweite aktive Region und
einen zweiten Außenumfangsabschnitt, der auf einem Außenumfang der zweiten aktiven Region angeordnet ist,
wobei die Isolationsschicht und die Halbleiterschicht nicht in der zweiten aktiven Region angeordnet sind und wobei
die Dummy-Gate-Elektrode in dem ersten Außenumfangsabschnitt angeordnet ist und nicht in dem zweiten Außenumfangsabschnitt angeordnet ist.

## Revendications

1. Dispositif à semi-conducteur comprenant :
un substrat SOI comprenant une première région active (1Ac) et une région d'isolation d'élément (1Iso) agencée en contact avec la première région active, le substrat SOI comprenant un substrat de support, une couche isolante (BOX) formée sur le substrat de support, et une couche semi-conductrice formée sur la couche isolante ;
une électrode de grille (GE1) formée sur la couche semi-conductrice dans la première région active via un film isolant de grille (GI1) ;
une région de source/drain (SD1) formée dans la couche semi-conductrice des deux côtés de l'électrode de grille ;
une électrode de grille factice (DGE1) formée dans la région d'isolation d'élément, et isolée électriquement de l'électrode de grille ; et
un film de paroi latérale (DSW) formé des deux côtés de l'électrode de grille factice,
dans lequel la région d'isolation d'élément est constituée d'un film isolant (STI) enfoui dans une tranchée plus profonde que la couche isolante, et
le film de paroi latérale est agencé le long d'une limite entre la première région active et la région d'isolation d'élément.

2. Dispositif à semi-conducteur selon la revendication 1,
dans lequel le film de paroi latérale est agencé pour correspondre à ou chevaucher la limite entre la première région active et la région d'isolation d'élément.

3. Dispositif à semi-conducteur selon la revendication 2, comprenant en outre
un bouchon de contact formé sur la région de source/drain.

4. Dispositif à semi-conducteur selon la revendication 2,
dans lequel une surface du film isolant est inférieure à une surface de la couche semi-conductrice au niveau de la limite entre la première région active et la région d'isolation d'élément.

5. Dispositif à semi-conducteur selon la revendication 4, comprenant en outre
un film de composé chimique composé d'un semi-conducteur constituant la région de source/drain et un métal est formé sur une surface de la région de source/drain.

6. Dispositif à semi-conducteur selon la revendication 5,
dans lequel la région de source/drain est une région d'impureté formée dans une partie empilée de la couche semi-conductrice et une couche épitaxiale entre la couche semi-conductrice et le film de composé chimique.

7. Dispositif à semi-conducteur selon la revendication 6,
dans lequel une extrémité du film de paroi latérale est positionnée au-dessus de la couche épitaxiale.

8. Dispositif à semi-conducteur selon la revendication 2,
dans lequel la région d'isolation d'élément comprend :
une première partie périphérique externe positionnée sur une périphérie externe de la première région active ;
une seconde région active ; et
une seconde partie périphérique externe positionnée sur une périphérie externe de la seconde région active,
la couche isolante et la couche semi-conductrice ne sont pas agencées dans la seconde région active, et
l'électrode de grille factice est agencée dans la première partie périphérique externe et n'est pas agencée dans la seconde partie périphérique externe.
